# EUROPEAN PATENT APPLICATION

(11) **EP 4 836 609 A1**
(43) Date of publication of application: **04.11.2026**
(21) Application number: 26168211.6
(22) Date of filing: 26.03.2026
(51) Int. Cl.: H05K 7/14, E04H 5/02, H05K 7/20, E04H 5/00

(54) **DATA CENTRE**

(71) Applicant: Sweet Project Holdings Limited, London, Greater London EC4M 7AU (GB)
(72) Inventor: WAUGH, Andrew, Greater London, EC4M 7AU (GB); BATEMAN, Peter, Greater London, EC4M 7AU (GB); EGLEN, Matthew, Greater London, EC4M 7AU (GB)
(74) Representative: Reddie & Grose LLP

(57) **Abstract**

A modular data centre (100) including a plurality of power supply modules (104) and a data hall (102) for housing a plurality of computer systems (502) is provided. The data hall (102) has a first end portion (114), a second end portion (116), and one or more middle portions (118) arranged in a repeating linear fashion between the end portions to form the data hall (102). Each portion has an associated power supply module (104) configured to provide power required by that portion during operation. Each power supply module (104) is structurally separate from its associated portion. A method for building a modular data centre, a kit of parts, and a method of assembling a modular data centre are also provided.

## Description

### FIELD OF INVENTION

The present disclosure relates to data centre infrastructure, and more particularly to a modular data centre, a method for building a modular data centre, a kit of parts for a modular data centre, and a method of assembling a modular data centre, designed for scalable and efficient deployment using prefabricated components and standardised power supply modules.

### BACKGROUND

The rapid advancement and adoption of artificial intelligence technologies across numerous industries has created an unprecedented demand for data processing and storage capabilities. From healthcare diagnostics to financial modeling, autonomous vehicles to natural language processing, AI applications require substantial computational resources that can only be provided by robust data centre infrastructure. As organizations increasingly integrate AI into their core operations, the need for data centre capacity continues to grow at an accelerating pace. This growing reliance on computational infrastructure has placed significant pressure on data centre providers to deliver facilities that can accommodate both current demands and anticipated future growth.

Traditional data centre designs often lack the flexibility required to meet varying operational demands. Organizations may need to scale their computing capacity up or down based on changing business requirements, seasonal fluctuations, or evolving technological needs. Different clients may have different power requirements, ranging from relatively modest installations to large-scale deployments requiring tens of megawatts of IT power. Furthermore, different computing applications may require different rack configurations, cooling arrangements, or power densities. This creates a demand for data centre solutions that can be scalable and easily reconfigured without significant disruption to ongoing operations.

Furthermore, conventional data centre design processes and construction methods are often time-consuming and expensive, requiring extensive initial site-specific design work and lengthy and expensive on-site building work with long deployment timelines. Traditional construction approaches typically involve bespoke designs where structural elements such as columns, beams, and wall panels are individually specified for each project. This results in a large number of different component types, each requiring separate manufacturing processes, quality control procedures, and installation techniques. The complexity of coordinating numerous unique components on a construction site can lead to delays, increased labour costs, coordination conflicts, and potential quality issues. In a rapidly evolving technological landscape, organizations require data centre solutions that can be deployed quickly with scalable flexibility to meet urgent capacity needs while remaining cost-effective.

Some approaches to addressing these challenges have involved containerized data centre solutions. These typically involve pre-fabricated units that house computing equipment, power systems, and cooling infrastructure within shipping container-sized enclosures. While such approaches can offer faster deployment times compared to traditional construction, they are often limited in scale and may not provide the same level of flexibility as purpose-built facilities. Additionally, the arrangement and integration of power supply systems, cooling infrastructure, and computing space in such modular approaches may not be optimized for larger-scale deployments or for facilities that need to accommodate multiple different client requirements.

It has been appreciated that a data centre design approach is needed that overcomes one or more of these problems.

### SUMMARY

The invention is defined in the independent claims. Embodiments of the invention are set out in the dependent claims.

According to a first aspect, a modular data centre is provided. The modular data centre comprises a plurality of power supply modules and a data hall for housing a plurality of computer systems. The data hall has a first end portion, a second end portion, and one or more middle portions arranged in a repeating linear fashion between the first end portion and the second end portion so as to form the data hall. Each of the first end portion, the second end portion, and the one or more middle portions has a respective one of the plurality of power supply modules associated with it that is configured to provide a power required by that portion when the data centre is in operation. Each power supply module is structurally separate from its associated first end portion, second end portion or middle portion which affords additional resilience between the portions.

This modular arrangement addresses the flexibility and scalability challenges identified in conventional data centre designs. By arranging the data hall as a series of end portions and middle portions in a repeating linear fashion, the data centre can be readily scaled to meet varying IT power requirements simply by adjusting the number of middle portions. The association of each portion with its own power supply module ensures that power capacity scales proportionally with the data hall size, eliminating the need for oversized or undersized power infrastructure. The structural separation between power supply modules and their associated portions provides operational flexibility and facilitates maintenance without disrupting computing operations. The structural separation also increases the safety of the data centre.

The one or more middle portions may be a plurality of middle portions, and each of the plurality of middle portions may have the same structure. This repeatable standardisation of middle portion structure enables efficient manufacturing and construction processes, as identical components can be mass-produced and assembled in a repeatable manner, reducing construction time and costs and increased site safety and product quality compared to bespoke designs.

The data hall may further have a first intermediate portion and a second intermediate portion, the first intermediate portion and the second intermediate portion positioned adjacent to one another and between two of the one or more middle portions, the first intermediate portion and the second intermediate portion configured to separate the data hall into a first sub-hall and a second sub-hall. This configuration enables the data centre to accommodate multiple different clients or operational requirements within a single facility while maintaining separation between different computing environments. It can also account for power supply redundancy requirements, as each portion can have its own redundancy power supply according to an operator's specifications.

The data hall may be symmetric in layout about the join between the first intermediate portion and the second intermediate portion. Such symmetry simplifies the design process and enables efficient use of repeatable designs resulting in standardised components throughout the facility.

Each of the power supply modules may be identical. The use of identical power supply modules enables mass production of these units, reducing manufacturing costs and lead times while ensuring consistent performance across the data centre.

Each of the power supply modules may be separated from the data hall by a gap of at least 1m, at least 2m, at least 3m, or at least 5m. This separation provides safety benefits and facilitates maintenance access to both the power supply modules and the data hall structure, as well as providing increased fire safety by separating many flammable components, such as fuel tanks and lithium ion batteries that may be housed within the power supply modules, from the data hall.

Each of the power supply modules may be configured to provide either or both of 1.5 MW of IT power and 2.4 MW of total power. These power specifications are selected to align with readily available generator and electrical equipment sizes, enabling faster procurement and deployment compared to custom-specified power systems.

Each of the first end portion, the second end portion, and the one or more middle portions may be configured to house the plurality of computer systems in one or more rows. This row-based arrangement facilitates efficient organisation of computing equipment and enables standardised cooling and power distribution approaches.

Each row may be associated with a hot aisle. The one or more rows may comprise pairs of rows, each pair of rows having a contained hot aisle between the two rows; or the one or more rows may comprise single rows, each single row having a contained hot aisle associated with only that single row; or any combination of the above. The hot aisle containment configuration improves cooling efficiency by separating hot exhaust air from cool supply air, reducing energy consumption for cooling operations.

Each row may be configured to comprise computer systems that require an average power of 250 kW, 375 kW, or 750 kW, and/or that have a maximum power requirement of 300 kW, 500 kW, or 1000 kW. These power densities are selected to accommodate typical computing workloads while providing headroom for peak demand periods.

The plurality of power supply modules may comprise one or more additional power supply modules in addition to the power supply modules associated with the first end portion, the second end portion, and the one or more middle portions. The additional power supply modules may be configured to provide one or more of: a power supply for one or more logistics buildings of the modular data centre; a power supply for one or more administrative buildings of the modular data centre; or a redundancy power supply for the modular data centre. This arrangement ensures that ancillary facilities receive adequate power while maintaining redundancy for operational resilience.

The plurality of power supply modules may be arranged linearly and adjacent to the data hall, such that the power supply module associated with each of the first end portion, the second end portion, and the one or more middle portions is adjacent to its associated portion. This linear arrangement minimises cable runs between power supply modules and their associated portions, reducing electrical losses and installation complexity, as well as enabling easy scalability of the design without requiring rearrangement of the power supply for different sizes of data centre.

Each of the first end portion, the second end portion and the one or more middle portions may comprise a modular cooling unit that is configured to provide a cooling required by that portion when the data centre is in operation. The modular cooling units may be dry cooling units, distributed chilled liquid cooling units, or a hybrid comprising dry cooling units and distributed chilled liquid cooling units. The association of cooling units with each portion ensures that cooling capacity scales with computing capacity, and the availability of different cooling technologies enables adaptation to different climatic conditions and efficiency and cost requirements.

A superstructure and a facade of the first end portion, the second end portion, and the one or more middle portions may be constructed from prefabricated components. The prefabricated components may comprise prefabricated superstructure and prefabricated facade components, which may optionally be precast concrete components. The use of prefabricated components enables off-site manufacturing under controlled conditions, improving quality and reducing on-site construction time compared to traditional cast-in-place construction methods. Furthermore, compared to typical steel construction, precast concrete construction can provide improved fire resistant properties.

The number of distinct types of prefabricated superstructure and facade components may be no more than 50, or no more than 40, or no more than 30, or no more than 29. This limitation on component variety enables mass production efficiencies and simplifies logistics, quality control, and installation procedures.

The prefabricated superstructure components may comprise prefabricated columns, prefabricated beams, and prefabricated floor planks, and the prefabricated facade components may comprise prefabricated external wall panels. The number of distinct types of prefabricated column may be no more than 15, no more than 10, or no more than 7. The number of distinct types of prefabricated beam may be no more than 30, no more than 20, or no more than 17. The number of distinct types of prefabricated floor planks may be no more than 10, no more than 5, or no more than 2. The number of distinct types of prefabricated external wall panels may be no more than 10, no more than 5, no more than 4, or no more than 3. Any combination of the above limitations may apply. These constraints on component variety enable high-volume production of standardised elements, reducing per-unit costs and enabling faster delivery compared to bespoke component manufacturing.

Each of the columns may have the same cross section. The cross section may be a minimum value that is suitable for all structural requirements, such as 400mm by 400mm, 425mm by 425mm, 450mm by 450mm, 475mm by 475mm, 500mm by 500mm, 525mm by 525mm, 550mm by 550mm, 575 by 575mm, 600mm by 600mm, 625mm by 625mm, 650mm by 650mm, 675mm by 675mm, or 700mm by 700mm. In other cases, non-square columns may be used, such as rectangular or 'T' shaped columns. Standardised column cross sections simplify structural design and enable the use of common, repeatable and standardised connection details throughout the structure.

The modular data centre may further comprise prefabricated services distribution modules. The prefabricated services distribution modules may comprise main services distribution modules and above rack distribution modules. The main services distribution modules may contain one or more of pipework, ductwork, power line containment, and data line containment. The above rack services distribution modules may be configured to distribute data lines and power lines to the plurality of computer systems. The use of prefabricated services distribution modules enables rapid installation of these services, with improved site safety due to the limited need for workers to operate overhead and at height installing piping, cables, and so forth, such as is typically required in traditional data centre construction.

The modular data centre may further comprise a service corridor integral to the data hall and running through the first end portion, the second end portion, and the one or more middle portions along an edge of the data hall adjacent the plurality of power supply modules. The main services distribution modules may be fixed within the service corridor. The service corridor may have a width of 4m. This service corridor facilitates the routing of power and cooling services from the power supply modules to the computing equipment, as well as the safe installation, operation and maintenance of the services. Having the service corridor along an edge of the data hall adjacent the plurality of power supply modules minimises power cable travel length.

The modular data centre may further comprise prefabricated service modules. The use of prefabricated service modules enables rapid installation of mechanical and electrical plant equipment, as well as cost savings due to the use of standardised service modules that can be produced at scale for multiple different data centres, rather than designing bespoke service modules for each data centre.

The data hall may have a length in the direction in which the one or more middle portions are arranged in a repeating linear fashion, and a width in a horizontal direction perpendicular to the length. Each of the first end portion, the second end portion, and the one or more middle portions may comprise a plurality of columns, the columns of the first end portion, the second end portion, and the one or more middle portions being arranged with a common spacing in at least one of the length direction and the width direction. The columns may have a first common spacing in the length direction of between 6000mm and 6200mm, or between 6060mm and 6100mm, such as 6080mm. The columns may have a second common spacing in the width direction of between 1200mm and 12400mm, or between 1220mm and 12200mm, such as 12160mm. The second common spacing may be double the first common spacing. These specific column spacings are selected to accommodate various server rack configurations used by different computing equipment providers and data centre operators, enabling the data centre to serve multiple different client requirements without structural modifications.

The first end portion and a first adjacent one of the one or more middle portions may have a plurality of shared columns along a boundary between the first end portion and the first adjacent one of the one or more middle portions in the width direction. The second end portion and a second adjacent one of the one or more middle portions may have a plurality of shared columns along a boundary between the second end portion and the second adjacent one of the one or more middle portions in the width direction. This sharing of columns at portion boundaries reduces the total number of columns required and simplifies the structural connections between adjacent portions.

The modular data centre may further comprise a logistics building having a plurality of columns, the columns of the logistics building having the same common spacing in at least one of the length direction and the width direction as the first end portion, the second end portion, and the one or more middle portions. The logistics building may be attached to an end, in the length direction, of the data hall. The logistics building may have the same width as the data hall. The use of common column spacing between the data hall and logistics building enables the use of the same prefabricated components for both structures, further increasing manufacturing volumes and reducing costs and construction and logistic complexities.

The data hall may comprise one floor, two floors, or three floors. This flexibility in floor count enables the data centre to be adapted to different site constraints and capacity requirements.

The data centre may be configured to provide an IT power of 1.5 MW, 3 MW, 4.5 MW, 9 MW, 18 MW, 27 MW, 36 MW, 45 MW, 54 MW, 72 MW or 108 MW. These power levels represent multiples of the base 1.5 MW module, demonstrating the scalability of the modular approach from small installations to large-scale deployments.

The modular data centre may comprise the plurality of computer systems housed within the data hall. The data hall may be divided into a plurality of areas, each of the plurality of areas housing computer systems of a different type. Each type of computer system may have a different footprint within the data hall. The data hall may comprise partitions between each of the plurality of areas. This arrangement enables the data centre to accommodate multiple different clients or computing applications within a single facility while maintaining secure separation between different operational environments.

According to a second aspect, a method for building a modular data centre comprising a data hall is provided. The method comprises: receiving an IT power requirement of the data hall; receiving an IT power specification of a first end portion of the data hall, a second end portion of the data hall, and a middle portion of the data hall, each portion for housing a plurality of computer systems; determining a minimum number of middle portions required such that the sum of the IT power specifications of the first end portion, the second end portion, and the middle portions is greater or equal to the IT power requirement; determining a modular data centre plan, including determining a data hall plan by arranging the middle portions in a repeating linear fashion between the first end portion and the second end portion; and building the modular data centre, including building the data hall according to the determined data hall plan.

This method addresses the time-consuming and expensive nature of conventional data centre design and construction processes. By determining the number of middle portions based on the IT power requirement and arranging standardised portions in a repeating linear fashion, the design process is simplified and accelerated compared to bespoke design approaches. The method enables rapid scaling of data centre capacity to meet specific client requirements while maintaining the benefits of standardised construction.

The number of middle portions may be two or more middle portions, and each of the two or more middle portions may have the same structural plan. This standardisation enables efficient design reuse and simplifies the construction process.

The data hall plan may further have a first intermediate portion and a second intermediate portion. Determining the data hall plan may further comprise arranging the first intermediate portion and the second intermediate portion positioned adjacent to one another and between two of the two or more middle portions, the first intermediate portion and the second intermediate portion configured to separate the data hall into a first sub-hall and a second sub-hall. The data hall plan may be symmetric in layout about the join between the first intermediate portion and the second intermediate portion. This configuration enables the method to produce data centres that can accommodate multiple different clients or operational requirements. It can also account for power supply redundancy requirements, as each portion can have its own redundancy power supply according to an operator's specifications.

Each of the first end portion, the second end portion, and the middle portions may have a respective power supply module associated with it that is configured to provide a power required by that portion when the data centre is in operation. Determining the modular data centre plan may further include arranging each power supply module adjacent to and structurally separate from its associated first end portion, second end portion or middle portion. Each power supply module may be identical. Each of the power supply modules may be separated, in the determined modular data centre plan, from the data hall by a gap of at least 1m, at least 2m, at least 3m, or at least 5m. Each of the power supply modules may be configured to provide either or both of 1.5 MW of IT power and 2.4 MW of total power. These features ensure that the method produces data centres with appropriately scaled and positioned power infrastructure. Furthermore, a separation between the power supply modules and the data hall provides safety benefits and facilitates maintenance access to both the power supply modules and the data hall structure, as well as providing increased fire safety by separating many flammable components, such as fuel tanks and lithium ion batteries that may be housed within the power supply modules, from the data hall.

Each of the first end portion, the second end portion, and the one or more middle portions may be configured to house the plurality of computer systems in one or more rows. Determining the data hall layout may include determining an arrangement of computer systems within the data hall. Each row may be associated with a hot aisle. The one or more rows may comprise pairs of rows, each pair of rows having a contained hot aisle between the two rows; or the one or more rows may comprise single rows, each single row having a contained hot aisle associated with only that single row; or any combination of the above. Each row may be configured to comprise computer systems that require an average power of 250 kW, 375 kW, or 750 kW, and/or that have a maximum power requirement of 300 kW, 500 kW, or 1000 kW. These features enable the method to produce data centres with efficient computing equipment arrangements.

Arranging the power supply modules may comprise arranging the power supply modules linearly and adjacent to the data hall, such that the power supply module associated with each of the first end portion, the second end portion, and the one or more middle portions is adjacent to its associated portion. This arrangement minimises infrastructure distribution complexity in the resulting data centre, and enables easy scaling of the data centre without requiring rearrangement of the power supply modules.

The method may further comprise determining a number of additional power supply modules in addition to the power supply modules associated with the first end portion, the second end portion, and the one or more middle portions. The additional power supply modules may be configured to provide one or more of: a power supply for one or more logistics buildings of the modular data centre; a power supply for one or more administrative buildings of the modular data centre; or a redundancy power supply for the modular data centre. Determining the modular data centre plan may further include arranging the additional power supply modules adjacent to and structurally separate from the data hall. This ensures that the method accounts for all power requirements of the complete data centre facility while maintaining redundancy for operational resilience.

Each of the first end portion, the second end portion and the one or more middle portions may be configured to comprise a modular cooling unit that is configured to provide a cooling required by that portion when the data centre is in operation. The modular cooling units may be dry cooling units, distributed chilled liquid cooling units, or a hybrid comprising dry cooling units and distributed chilled liquid cooling units. This ensures appropriate cooling capacity in the resulting data centre.

The method may further comprise determining, based on the determined data hall layout, a plurality of prefabricated components required for constructing a superstructure and a facade of the data hall. The prefabricated components may comprise prefabricated superstructure and prefabricated facade components, which may optionally be precast concrete components. Building the data hall according to the determined data hall plan may comprise: receiving the determined plurality of prefabricated components at a site for the data hall; and assembling the determined plurality of prefabricated components on-site. This approach enables rapid on-site construction using components manufactured off-site under controlled conditions, giving rise to high quality components at a low, high-production-volume cost.

The number of distinct types of prefabricated superstructure and facade components may be no more than 50, or no more than 40, or no more than 30, or no more than 29. The prefabricated superstructure components may comprise prefabricated columns, prefabricated beams, and prefabricated floor planks, and the prefabricated facade components may comprise prefabricated external wall panels. The number of distinct types of prefabricated column may be no more than 15, no more than 10, or no more than 7. The number of distinct types of prefabricated beam may be no more than 30, no more than 20, or no more than 17. The number of distinct types of prefabricated floor planks may be no more than 10, no more than 5, or no more than 2. The number of distinct types of prefabricated external wall panels may be no more than 10, no more than 5, no more than 4, or no more than 3. Any combination of the above limitations may apply. Each of the columns may have the same cross section. The cross section may be a minimum value that is suitable for all structural requirements, such as 400mm by 400mm, 425mm by 425mm, 450mm by 450mm, 475mm by 475mm, 500mm by 500mm, 525mm by 525mm, 550mm by 550mm, 575 by 575mm, 600mm by 600mm, 625mm by 625mm, 650mm by 650mm, 675mm by 675mm, or 700mm by 700mm. In other cases, non-square columns may be used, such as rectangular or 'T' shaped columns. These constraints enable the method to leverage mass production efficiencies in component manufacturing.

The method may further comprise determining, based on the determined data hall layout, a plurality of prefabricated services distribution modules. Building the data hall according to the determined data hall plan may comprise: receiving the determined plurality of prefabricated services distribution modules at a site for the data hall; and installing the plurality of prefabricated services distribution modules. The prefabricated services distribution modules may comprise main services distribution modules and above rack distribution modules. The main services distribution modules may contain one or more of pipework, ductwork, power line containment, and data line containment. The above rack services distribution modules may be configured to distribute data lines and power lines to the plurality of computer systems. The use of prefabricated services distribution modules enables rapid installation of these services, with improved site safety due to the limited need for workers to operate overhead and at height installing piping, cables, and so forth, such as is typically required in traditional data centre construction.

Determining the modular data hall plan may further include determining a service corridor plan integral to the data hall and running through the first end portion, the second end portion, and the one or more middle portions along an edge of the data hall. Building the modular data centre may comprise installing the prefabricated main services distribution modules within the service corridor. The service corridor may have a width of 4m. This ensures adequate provision for the safer installation of service distribution in the resulting data centre.

The method may further comprise determining, based on the determined data hall layout, a plurality of prefabricated service modules. Building the data hall according to the determined data hall plan may comprise: receiving the determined plurality of prefabricated service modules at a site for the data hall; and installing the plurality of prefabricated service modules. This enables rapid construction of the data centre, as well as cost savings due to the use of standardised service modules that can be produced at scale for multiple different data centres, rather than designing bespoke service modules for each data centre.

The data hall plan may have a length in the direction in which the one or more middle portions are arranged in a repeating linear fashion, and a width in a horizontal direction perpendicular to the length. Each of the first end portion, the second end portion, and the middle portions may comprise a plurality of column positions, the column positions of the first end portion, the second end portion, and the one or more middle portions being arranged with a common spacing in at least one of the length direction and the width direction. The column positions may have a first common spacing in the length direction of between 6000mm and 6200mm, or between 6060mm and 6100mm, such as 6080mm. The columns may have a second common spacing in the width direction of between 1200mm and 12400mm, or between 1220mm and 12200mm, such as 12160mm. The second common spacing may be double the first common spacing. These specific column spacings are selected to accommodate various server rack configurations used by different computing equipment providers and data centre operators, enabling the data centre to serve multiple different client requirements without structural modifications.

The first end portion and a first adjacent middle portion may have a plurality of shared column positions along a boundary between the first end portion and the first adjacent middle portion in the width direction. The second end portion and a second adjacent middle portion may have a plurality of shared column positions along a boundary between the second end portion and the second adjacent middle portion in the width direction. This reduces the total number of columns required in the resulting structure and simplifies the structural connections between adjacent portions.

The method may further comprise determining a logistics building plan having a plurality of column positions, the column positions of the logistics building having the same common spacing in at least one of the length direction and the width direction as the first end portion, the second end portion, and the middle portions. The logistics building plan may be attached to an end, in the length direction, of the data hall plan. The logistics building plan may have the same width as the data hall plan. This enables the use of common components for both the data hall and logistics building, further increasing manufacturing volumes and reducing costs and construction and logistic complexities.

The data hall plan may comprise one floor, two floors, or three floors. The modular data centre may be configured to provide an IT power of 1.5 MW, 3 MW, 4.5 MW, 9 MW, 18 MW, 27 MW, 36 MW, 45 MW, 54 MW, 72 MW or 108 MW. These options demonstrate the flexibility of the method in producing data centres of varying scales.

According to a third aspect, a kit of parts for a modular data centre is provided. The modular data centre comprises a plurality of power supply modules and a data hall for housing a plurality of computer systems. The data hall has a first end portion, a second end portion, and one or more middle portions arranged in a repeating linear fashion between the first end portion and the second end portion so as to form the data hall. The kit of parts comprises: the plurality of power supply modules; and a plurality of prefabricated components configured to be assembled into a structure of the data hall.

This kit of parts approach addresses the lengthy deployment timelines associated with conventional data centre construction. By providing pre-manufactured power supply modules and prefabricated structural components, the kit enables rapid on-site assembly with reduced reliance on skilled on-site labour and wet trades. The standardised nature of the components enables quality control during manufacturing and predictable assembly processes on site.

The prefabricated components may comprise prefabricated superstructure and prefabricated facade components, which may optionally be precast concrete components. The number of distinct types of prefabricated superstructure and facade components may be no more than 50, or no more than 40, or no more than 30, or no more than 29. These constraints enable efficient manufacturing and logistics for the kit components.

The prefabricated superstructure components may comprise prefabricated columns, prefabricated beams, and prefabricated floor planks, and the prefabricated facade components may comprise prefabricated external wall panels. The number of distinct types of prefabricated column may be no more than 15, no more than 10, or no more than 7. The number of distinct types of prefabricated beam may be no more than 30, no more than 20, or no more than 17. The number of distinct types of prefabricated floor planks may be no more than 10, no more than 5, or no more than 2. The number of distinct types of prefabricated external wall panels may be no more than 10, no more than 5, no more than 4, or no more than 3. Any combination of the above limitations may apply. Each of the columns may have the same cross section. The cross section may be 500mm by 500mm, 600mm by 600mm, or 700mm by 700mm. These standardised components enable high-volume manufacturing and simplified assembly procedures.

The kit of parts may further comprise prefabricated services distribution modules. The prefabricated services distribution modules may comprise main services distribution modules and above rack distribution modules. The main services distribution modules may contain one or more of pipework, ductwork, power line containment, and data line containment. The above rack services distribution modules may be configured to distribute data lines and power lines to the plurality of computer systems. These components enable rapid installation of power and cooling distribution infrastructure.

The kit of parts may further comprise prefabricated service modules. The use of prefabricated service modules enables rapid installation of mechanical and electrical plant equipment, as well as cost savings due to the use of standardised service modules that can be produced at scale for multiple different data centres, rather than designing bespoke service modules for each data centre.

According to a fourth aspect, a method of assembling a modular data centre is provided. The method comprises: receiving the kit of parts according to the third aspect; and assembling the kit of parts.

This method enables rapid deployment of data centre capacity by leveraging pre-manufactured components. The assembly process is simplified compared to conventional construction because the components are designed for efficient on-site assembly, reducing construction time and enabling faster time-to-operation for the data centre.

### BRIEF DESCRIPTION OF FIGURES

Embodiments of the invention will be described, by way of example, with reference to the following drawings, in which:
FIG. 1 illustrates an isometric view of a modular data centre.
FIG. 2 illustrates an isometric view of the modular data centre of FIG. 1.
FIG. 3 illustrates a floor plan view of the modular data centre of FIG. 1.
FIG. 4 illustrates an isometric view of a prefabricated structural framework of a data hall.
FIG. 5 illustrates an isometric view of a sub-hall of a modular data centre.
FIG. 6 illustrates a floor plan view of a sub-hall of a modular data centre.
FIG. 7 illustrates an isometric view of a power supply module arrangement.
FIG. 8 illustrates a flowchart of a method for building a modular data centre.
FIG. 9 illustrates a flowchart of a method for assembling a modular data centre.

Common reference numerals are used throughout the figures to indicate similar features.

### DETAILED DESCRIPTION

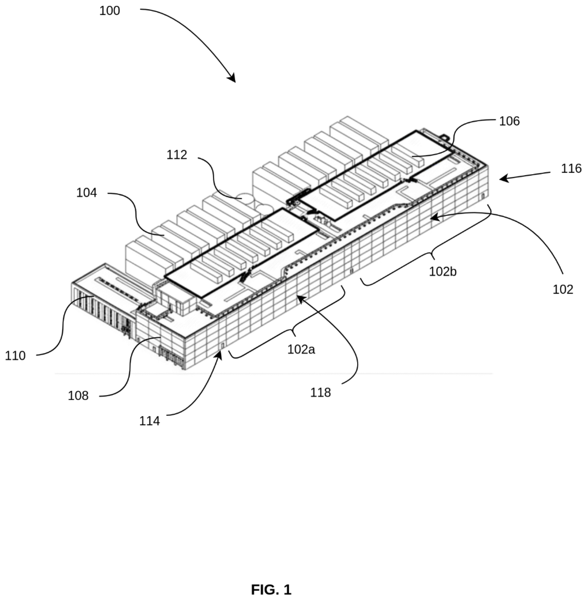

FIG. 1 illustrates an isometric view of a modular data centre 100. The modular data centre 100 comprises a data hall 102 configured to house a plurality of computer systems. The data hall 102 is divided into a first sub-hall 102a and a second sub-hall 102b. The first sub-hall 102a and the second sub-hall 102b may be configured to operate independently, enabling the data hall 102 to serve two different clients independently when the data hall 102 is split down the middle.

A plurality of power supply modules 104 are arranged linearly adjacent to the data hall 102. Each power supply module 104 is structurally separate from the data hall 102, with a gap between each power supply module 104 and the data hall 102. The power supply modules 104 are configured to provide electrical power to the data hall 102.

A plurality of modular cooling units 106 are positioned on the roof of the data hall 102. The modular cooling units 106 are arranged in rows along the length of the data hall 102 and are configured to provide cooling to the data hall 102.

Sprinkler water tanks 112 are located near the power supply modules 104. sprinkler water tanks 112 are configured to supply water for a sprinkler fire suppression system of the modular data centre 100.

A logistics building 108 is attached at one end of the data hall 102. The logistics building 108 shares the same width as the data hall 102. The logistics building 108 may house lifts, stores, delivery entrances, and other functional sections required for operation of modular data centre 100. An administrative building 110 is positioned adjacent to the logistics building 108. The administrative building 110 is configured to house personnel and administrative functions associated with the modular data centre 100. For example, the administrative building 110 may take the form of an office building.

The data hall 102 includes a first end portion 114 at one end, a second end portion 116 at the opposite end, and one or more middle portions 118 arranged in a repeating linear fashion between the first end portion 114 and the second end portion 116. Each of the first end portion 114, the second end portion 116, and the middle portions 118 has a respective power supply module 104 associated with the respective portion. The respective power supply module 104 is configured to provide a power required by the associated portion when the modular data centre 100 is in operation. As illustrated, each of the first end portion 114, the second end portion 116, and the middle portions 118 has two power supply modules 104 associated with it, though in some cases more or fewer power supply modules 104 may be associated with each portion. In some cases, each portion may be able to have a different number of power supply modules 104 associated with it.

The modular data centre 100 illustrated in FIG. 1 is an exemplary configuration. The modular data centre 100 is configured to accommodate different numbers of middle portions 118 to change the size of the data hall 102. More middle portions 118 are included to increase the capacity of the data hall 102, or fewer middle portions 118 are included to decrease the capacity of the data hall 102. The modular data centre 100 is also configured to accommodate different numbers of sub-halls 102a, 102b to change the overall size of the modular data centre 100.

The use of repeatable portions of the data hall 102 provides significant advantages in the design and construction of data centres with varying capacities. By employing a standard template comprising the first end portion 114, the second end portion 116, and standardised middle portions 118, data halls of different sizes can be readily designed without requiring bespoke engineering work for each project. The middle portions 118 may each have the same structure, enabling efficient manufacturing and construction processes where identical components can be mass-produced and assembled in a repeatable manner. This standardisation reduces design time, as the structural, electrical, and cooling requirements of each middle portion 118 are predetermined and factored into the design of each portion, and so areautomatically scaled as needed. Furthermore, the association of each portion with its own power supply module 104 ensures that power capacity scales proportionally with the data hall 102 size, eliminating the need for complex recalculations of power infrastructure when adjusting data centre capacity. The repeatable nature of the middle portions 118 also simplifies procurement and logistics, as the same prefabricated components can be ordered in varying quantities depending on the required data hall 102 capacity, enabling faster deployment timelines compared to traditional bespoke construction approaches.

The modular data centre 100 is configured to accommodate different numbers of floors. The data hall 102 comprises one floor, two floors, or three floors depending on the capacity requirements. Each floor typically is similar to the floors below, with repetition in the fittings and may of the structural or facade elements of the modular data centre 100.

Fire travel distances within the modular data centre 100 are maintained within acceptable regardless of the number of floors or adjacent data halls added. This is due to the repeating, linear arrangement of the middle portions 118, whereby adding more middle portions 118 extends the data hall 102 in the length direction without adversely affecting the fire travel distances within each portion. Furthermore, due to the modular nature of the prefabricated wall panels, additional door panels can be added easily and as need to meet safety requirements as the modular data centre 100 is scaled.

The modular data centre 100 may be configured to accommodate different operator rack layouts. For example, the data hall 102 may be configured to accommodate operators such as Amazon, Google, Microsoft and Oracle rack configurations within the first sub-hall 102a and the second sub-hall 102b.

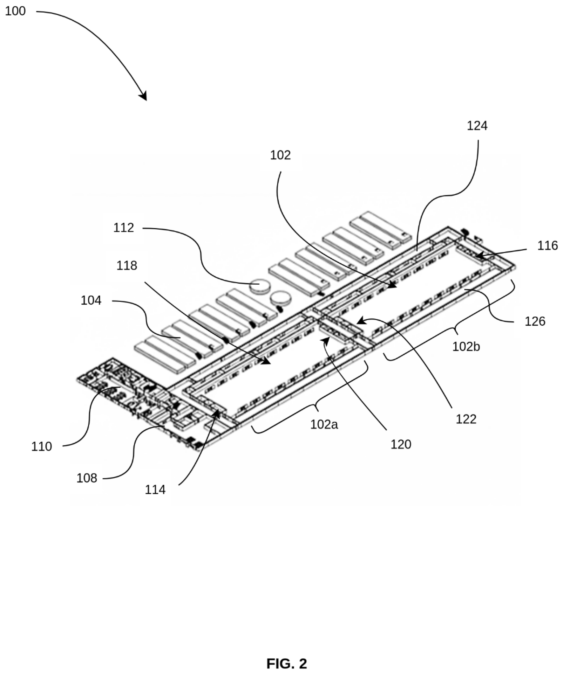

FIG. 2 illustrates an isometric view of the modular data centre 100 showing the spatial arrangement of the data hall 102, the power supply modules 104, and supporting facilities. The power supply modules 104 are arranged linearly and adjacent to the data hall 102, with a gap separating the power supply modules 104 from the data hall 102. The gap provides structural separation between the power supply modules 104 and the data hall 102. The power supply modules 104 are often positioned on the perimeter of data centre site, and may include screening cladding for visual screening from neighbouring properties.

A service corridor 124 runs along one edge of the data hall 102 adjacent to the power supply modules 104. The service corridor 124 extends through the first end portion 114, the second end portion 116, and the middle portions 118 along the edge of the data hall 102 that is adjacent to the power supply modules 104. The service corridor 124 is configured to house main services distribution, including pipework, ductwork, power line containment, and data line containment. The service corridor 124 contains static transfer switches positioned along the back wall for power distribution.

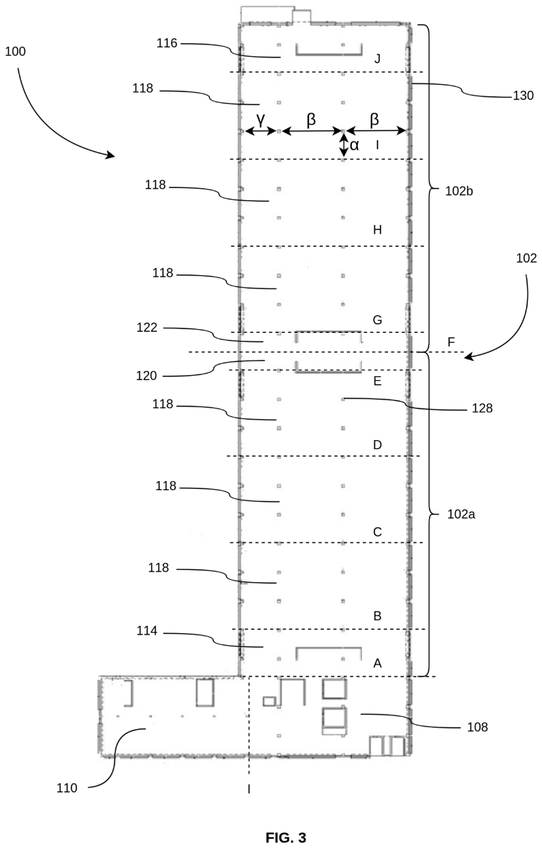

The service corridor 124 has a width of 4 metres compared to typical 3 metre corridors. The relatively large width of the service corridor 124, compared to typical service corridors, has been selected to accommodate installation, maintenance, and health and safety requirements. The column grid of the data hall 102 includes a 7 metre spacing anomaly instead of the standard 6080 mm spacing to accommodate the service corridor 124, as discussed further in relation to FIG. 3. The size of the service corridor 124 is particularly beneficial in providing the space to enable the installation of prefabricated, modular main services distribution modules.

The prefabricated main services distribution modules may be manufactured off-site and installed within the service corridor 124. The main services distribution modules may contain pipework, ductwork, power line containment, and data line containment. In some cases, the main services distribution modules may be approximately 6 metres in length and are configured to be hoisted into position and connected at regular intervals along the service corridor 124. This approach improves site safety by a reduction of site activities and hence the need for workers to install services overhead at height, as the modules are assembled at ground level in a factory environment before being transported to site and raised into position on site. The main services distribution modules may also be pre-commissioned and pre-tested before installation, increasing quality and reliability.

A cooling corridor 126 is located at one end of the data hall 102. The cooling corridor 126 functions as a plant room area where modular cooling units serving the data hall 102 environment are located. The cooling corridor 126 may include one or more prefabricated service modules. The prefabricated service modules may be manufactured off-site and installed within the cooling corridor 126. The use of prefabricated service modules enables rapid installation of mechanical and electrical plant equipment, as well as cost savings due to the use of standardised service modules that can be produced at scale for multiple different data centres, rather than designing bespoke service modules for each data centre. As with the prefabricated main services distribution modules, these prefabricated service modules may also be pre-commissioned and pre-tested before installation, increasing quality and reliability, and may be "plug and play".

A first intermediate portion 120 and a second intermediate portion 122 are positioned adjacent to one another between the middle portions 118. The first intermediate portion 120 and the second intermediate portion 122 are configured to separate the data hall 102 into the first sub-hall 102a and the second sub-hall 102b. The data hall 102 is symmetric in layout about the join between the first intermediate portion 120 and the second intermediate portion 122. The symmetric layout enables the first sub-hall 102a and the second sub-hall 102b to be configured identically, facilitating independent operation of each sub-hall for different clients.

The size of each sub-hall 102a, 102b may be based on a power supply redundancy requirement of a data hall operator. Each sub-hall 102a, 102b may be sized to accommodate a specific number of power supply modules 104 (through the number of middle portions 118) along with one or more redundancy power supply modules according to the operator's specifications. For example, if an operator has a requirement of one redundant power supply module for every six power supply modules, then the data hall 102 may be sized so as to have six power supply modules 104 in each sub-hall 102a, 102b along with one redundancy power supply module. This configuration enables each sub-hall 102a, 102b to have its own redundancy power supply according to the operator's specifications.

FIG. 3 illustrates a floor plan view of the modular data centre 100 showing key structural features, in particular columns 128 and external wall panels 130. The data hall 102 extends vertically across the plan with a series of regularly spaced columns 128 arranged in a grid pattern throughout the structure. External wall panels 130 form the perimeter walls of the data hall 102.

The columns 128 are arranged with consistent spacing indicated by Greek letters in FIG. 3. The symbol α represents a first common spacing between columns 128 in the length direction of the data hall 102. The first common spacing α is 6080 mm. The symbol β represents a second common spacing between columns 128 in the width direction of the data hall 102. The second common spacing β is 12160 mm, which is double the first common spacing α.

The first common spacing α and the second common spacing β have been found to enable the data hall 102 to accommodate different computer rack configurations used by different computing equipment providers and data centre operators, including hyperscalers such as Google, Microsoft, Amazon, and Oracle. The column spacings were carefully considered to ensure that the data hall 102 can accommodate the latest cabinet layouts, cabinet sizes, and the different operator requirements for spacing between cabinets. This enables the data centre to serve multiple different client requirements without structural modifications. The ability to accommodate different operators without structural modifications provides significant advantages. A single standardised data hall plan can be deployed across multiple different sites, reducing design costs and enabling faster deployment timelines. Furthermore, a single site can accommodate different operators within different sub-halls or tenant areas, with each operator's specific rack configuration fitting within the same structural grid. Additionally, if an operator vacates a portion of the data hall, the space can be readily repurposed for a different operator with different rack requirements without the need for costly and time-consuming structural alterations or the compromising of rack row quantities. This flexibility maximises the commercial utility of the data centre infrastructure and reduces the risk associated with long-term facility investments.

The symbol γ represents a third spacing between columns 128, which is 7000 mm. The third spacing γ accommodates the 4 metre width of the service corridor 124, as described above in relation to FIG. 2.

The columns 128 are precast concrete columns. Each column 128 has the same cross section, which may be 500mm by 500mm, 600mm by 600mm, or 700mm by 700mm. While not each column 128 may require this cross section from a structural, load-bearing perspective, having each column 128 the same cross section (e.g., the minimum cross section that any individual column 128 can be based on load-bearing requirements) design and manufacture of the columns 128 and modular data centre 100 can be greatly simplified.

Each column 128 includes corbels for beam connections. The number of corbels on each column 128 varies depending on the position of the column 128 within the structural grid and the number of floors in the data hall 102. Mid columns 128 positioned along the interior of the grid have three corbels per floor to receive beams from three directions. Corner columns 128 positioned at corners of the structure have two corbels per floor to receive beams from two directions. For example, a single-floor data hall 102, mid external columns 128 may have three corbels (along the external wall in either direction, and facing inwards) and corner may columns 128 have two corbels (along the two external walls forming the corner). For a two-floor data hall 102, mid external columns 128 have six corbels and corner columns 128 have four corbels. For a three-floor data hall 102, mid external columns 128 have nine corbels and corner columns 128 have six corbels. Internal columns may have four corbels per floor, one in each direction

The number of distinct types of prefabricated column 128 is preferably kept as low as possible, to simplify construction. For example, the number of distinct types of prefabricated column 128 may be no more than 15, no more than 10, or no more than 7. This limited number of column types enables mass production efficiencies, as high volumes of identical components can be manufactured, reducing per-unit costs and enabling faster delivery compared to bespoke component manufacturing. The standardisation of column types also simplifies logistics, quality control, and installation procedures, as workers become familiar with a limited set of components and connection details. The number of types of column required is kept to a minimum in part by the use of standardised column cross sections, which simplifies structural design and enables the use of common connection details throughout the structure, reducing the potential for errors during construction.

Dashed lines A to J are shown across the width of the data hall 102 in FIG. 3 to delineate the different portions of the data hall 102. The first end portion 114 is located between dashed lines A and B. The second end portion 116 is located at the opposite end of the data hall 102 after dashed line J. The first intermediate portion 120 is positioned between dashed lines E and F. The second intermediate portion 122 is positioned between dashed lines F and G, adjacent to the first intermediate portion 120. The first intermediate portion 120 and the second intermediate portion 122 separate the first sub-hall 102a from the second sub-hall 102b. Middle portions 118 are arranged between the first end portion 114 and the second end portion 116, and more particularly between the first end portion 114 and the first intermediate portion 120 and between the second intermediate portion 122 and the second end portion 116.

The size of the data hall 102 is varied by changing the number and arrangement of the middle portions 118. Additional middle portions 118 are added between the first end portion 114 and the first intermediate portion 120 to increase the size of the first sub-hall 102a. Additional middle portions 118 are added between the second intermediate portion 122 and the second end portion 116 to increase the size of the second sub-hall 102b. The first end portion 114, the second end portion 116, and adjacent middle portions 118 share columns 128 along boundaries between portions in the width direction. Accordingly, it will be appreciated that these are not necessarily structurally independent modules, but are designed in a repeatable manner such that the data hall plan can be easily made to any size specification required. Similarly, as the first intermediate portion 120 will often, in practice, always be adjacent to the second intermediate portion 122, these two portions can be treated together as a joint module, reflected in the fact that there is no line of columns between them (e.g., along line F).

The external wall panels 130 are prefabricated precast concrete panels. The use of precast concrete panels for the external walls provides several advantages over traditional cast-in-place construction methods. Precast panels are manufactured off-site in a controlled factory environment, enabling consistent quality and dimensional accuracy that may be difficult to achieve with on-site casting. The factory environment also allows production to continue regardless of weather conditions, reducing the risk of weather-related delays that commonly affect traditional construction projects.

The precast concrete panels are designed to be transported to site and lifted into position using cranes, significantly reducing on-site labour requirements compared to traditional masonry or cast-in-place concrete construction. This approach minimises the need for skilled wet trades on site, which can be a limiting factor in construction timelines and costs. The panels arrive at site ready for installation, eliminating the curing time associated with cast-in-place concrete and enabling faster overall construction schedules.

The number of distinct types of prefabricated external wall panels 130 is preferably kept as low as possible, for example no more than 10, no more than 5, or no more than 3 distinct types. This standardisation enables high-volume production of identical panels, reducing per-unit manufacturing costs through economies of scale. The limited variety of panel types also simplifies logistics, as fewer different components need to be tracked, stored, and transported to site. On-site installation is similarly simplified, as workers become proficient in handling and installing a limited set of panel configurations, reducing installation time and the potential for errors.

At the bottom of the floor plan in FIG. 3, the logistics building 108 is attached to the data hall 102. The logistics building 108 shares the same width as the data hall 102. The logistics building 108 is configured to house functional areas required for the operation of the modular data centre 100, including lifts, stores, delivery entrances, loading bays, and goods handling facilities. The logistics building 108 provides a centralised location for receiving and distributing equipment, supplies, and replacement components to the data hall 102. The attachment of the logistics building 108 to the data hall 102 enables efficient movement of equipment and personnel between the two structures without requiring external transit.

The columns 128 of the logistics building 108 have the same common spacing as the columns 128 of the data hall 102, enabling the logistics building 108 to be constructed as an extension of the data hall 102 using the same prefabricated components. This common column spacing provides several significant advantages. First, it enables the use of identical prefabricated beams, floor planks, and other structural components for both the data hall 102 and the logistics building 108, further increasing manufacturing volumes and reducing per-unit costs through economies of scale. Second, it simplifies logistics and inventory management, as fewer distinct component types need to be tracked, stored, and transported to site. Third, it reduces the potential for errors during construction, as workers become proficient in handling and installing a consistent set of components throughout the entire facility. Fourth, it enables seamless structural integration between the data hall 102 and the logistics building 108, simplifying the connection details at the interface between the two structures. Fifth, it provides flexibility for future modifications or expansions, as the consistent structural grid enables straightforward alterations without requiring bespoke engineering solutions.

Dashed line I separates the administrative building 110 from the logistics building 108. The administrative building 110 is positioned adjacent to the logistics building 108. The administrative building 100 functions as an office for the modular data centre 100, and uses a smaller structural grid of approximately 4 metres by 3 metres compared to the grid of the data hall 102. The administrative building 110 has a reduced floor-to-floor height of 4 metres compared to the 6 metre floor-to-floor height of the data hall 102. The administrative building 110 can configured for volumetric modularisation similar to portacabins, enabling rapid assembly from prefabricated volumetric units.

The smaller structural grid of the administrative building 110 is appropriate for office accommodation, where the spatial requirements differ from those of the data hall 102. Office spaces typically require smaller column-free spans to accommodate partition walls, individual offices, meeting rooms, and circulation corridors. The 4 metre by 3 metre grid provides sufficient flexibility for typical office layouts whilst enabling the use of lighter structural elements compared to the data hall 102. The reduced floor-to-floor height of 4 metres is similarly appropriate for office accommodation, where the ceiling heights required for computing equipment, cable management, and cooling infrastructure are not necessary. This differentiation in structural grid and floor height between the administrative building 110 and the data hall 102 enables each building to be optimised for its intended function whilst still benefiting from prefabricated construction methods.

The floor planks 138 of the data hall 102 are prefabricated precast concrete elements. The floor planks 138 are 2.4 metres wide and span the 12 metre bay width defined by the second common spacing β between columns 128. The floor planks 138 are supported by prefabricated beams that span between adjacent columns 128. The use of prefabricated floor planks 138 provides several advantages over traditional cast-in-place concrete floor construction. The floor planks 138 are manufactured off-site in a controlled factory environment, enabling consistent quality, dimensional accuracy, and surface finish that may be difficult to achieve with on-site casting. The factory environment also allows production to continue regardless of weather conditions, reducing the risk of weather-related delays. The floor planks 138 arrive at site fully cured and ready for installation, eliminating the curing time associated with cast-in-place concrete and enabling faster overall construction schedules.

The standardised 2.4 metre width of the floor planks 138 is selected to enable efficient transportation to site and handling during installation, whilst minimising the number of joints required across the floor surface. The number of distinct types of prefabricated floor planks 138 is preferably kept as low as possible, for example no more than 10, no more than 5, or no more than 2 distinct types. This standardisation enables high-volume production of identical floor planks 138, reducing per-unit manufacturing costs through economies of scale. The limited variety of floor plank types also simplifies logistics, as fewer different components need to be tracked, stored, and transported to site. On-site installation is similarly simplified, as workers become proficient in handling and installing a limited set of floor plank configurations, reducing installation time and the potential for errors.

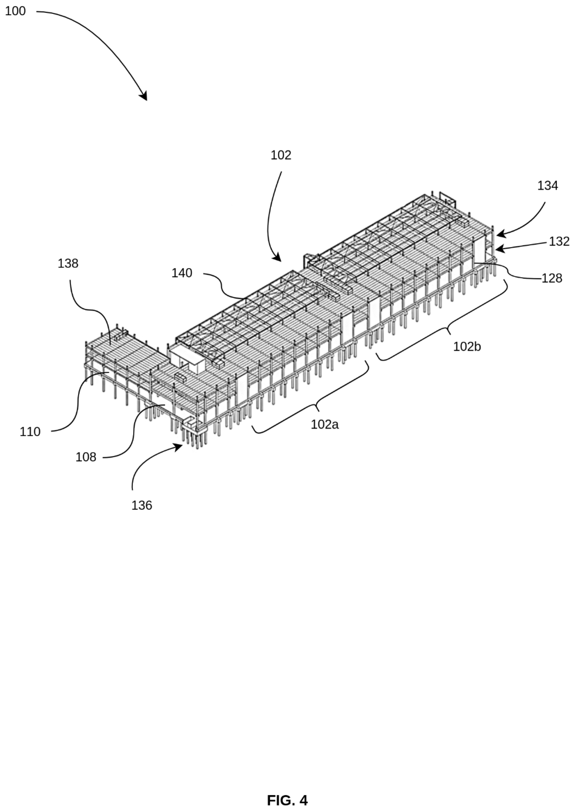

FIG. 4 illustrates an isometric view of the modular data centre 100 showing the prefabricated structural framework of the data hall 102. The data hall 102 structure comprises a series of columns 128 arranged in a regular grid pattern. The columns 128 support prefabricated beams that span between adjacent columns 128. The columns 128 are positioned with consistent spacing in both the length and width directions of the structure, corresponding to the first common spacing α and the second common spacing β described above in relation to FIG. 3.

As discussed in relation to FIGs. 1-3 above, the data hall 102 is divided into the first sub-hall 102a and the second sub-hall 102b.

Floor planks 138 span between the prefabricated beams to create floor surfaces across multiple levels. The floor planks 138 also eliminate the requirement for temporary platforms during construction. Similarly the external panels 130 at the roof level, once installed early during construction of the modular data centre 100, eliminate the requirement for temporary guarding and balustrading. enabling a more efficient and quicker build. The data hall 102 includes a ground floor 132 and a first floor 134. The floor planks 138 are supported by the prefabricated beams at each level, creating continuous floor surfaces across the ground floor 132 and the first floor 134. The prefabricated beams transfer loads from the floor planks 138 to the columns 128, which in turn transfer loads to a foundation 136.

The foundation 136 supports the columns 128 at the base of the structure. The foundation 136 comprises two independent foundations, one for the service yard area and one for the data hall 102 and other buildings, and is typically site specific and dependent on the underlying geology of a site. The foundation 136 may comprise a concrete slab in the service yard area for supporting the power supply modules 104 (not illustrated). The foundation 136 may also comprise piling under the data hall 102, as well as the logistics building 108 and administrative building 110, to provide a stable base for the entire structural framework of the data hall 102.

A cooling unit platform 140 is positioned on the roof of the data hall 102. The cooling unit platform 140 is configured to support the modular cooling units 106 described above in relation to FIG. 1 and FIG. 2. The cooling unit platform 140 provides a structural framework for mounting the modular cooling units 106 at roof level.

The logistics building 108 is attached at one end of the data hall 102, and the administrative building 110 is positioned adjacent to the logistics building 108. The logistics building 108 and the administrative building 110 may share the same prefabricated construction approach as the data hall 102. Alternatively, in some cases, the administrative building in particular may be constructed using a prefabricated (e.g., containerised) approach.

The structure illustrated in FIG. 4 demonstrates the modular nature of the construction, where standardised prefabricated components are assembled to form the complete data hall 102.

The prefabricated components include the columns 128, the prefabricated beams, the floor planks 138, and the cooling unit platform 140 . Each of these components is manufactured off-site and transported to site for assembly.

The regular spacing of columns 128 in the data hall 102 enables the repeating use of prefabricated wall panels 130 throughout the structure. Because the columns 128 are positioned at consistent intervals defined by the first common spacing α and the second common spacing β, as illustrated in FIG. 3, the external wall panels 130 can be manufactured to standard dimensions that fit precisely between adjacent columns 128. This regularity eliminates the need for custom-sized panels at different locations around the perimeter of the data hall 102, enabling all wall panels 130 to be produced from a limited number of standardised moulds. The consistent column spacing also ensures that connection details between wall panels 130 and columns 128 are identical throughout the structure, simplifying installation and reducing the potential for errors during construction. Furthermore, as the data hall 102 is extended by adding additional middle portions 118, the same standardised wall panels 130 can be used for each new portion without requiring any modification to the panel design or manufacturing process.

Prefabricated services distribution modules are installed within the service corridor 124. The prefabricated services distribution modules are installed as 6 metre long cassettes containing pre-assembled pipework, cable trays, and containment. The prefabricated services distribution modules are pre-commissioned and pre-tested off-site before installation. This approach enables rapid installation of services infrastructure whilst maintaining consistent high quality, as the modules are assembled and tested in a controlled factory environment before being transported to site.

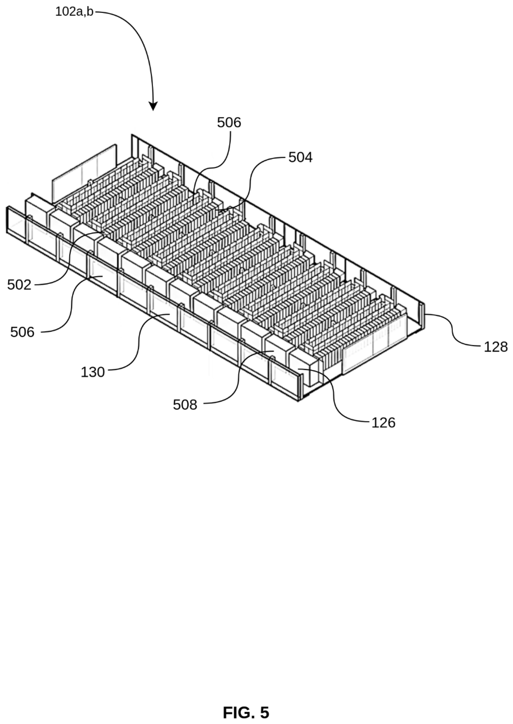

FIG. 5 illustrates an isometric view of a sub-hall 102a, 102b of the modular data centre 100 showing the arrangement of computer systems within the sub-hall 102a, 102b. The sub-hall 102a, 102b comprises a plurality of computer systems 502 arranged in rows 504. Each row 504 contains multiple computer systems 502 positioned in a linear arrangement across the width of the sub-hall 102a, 102b.

The rows 504 are organised in pairs, with each pair of rows 504 having a hot aisle 506 positioned between the two rows 504. The hot aisle 506 provides a contained area for hot exhaust air from the computer systems 502. Cold air enters the computer systems 502 from the front, passes through the computing equipment where heat is absorbed, and exits as hot exhaust air into the hot aisle 506. The containment of the hot aisle 506 prevents mixing of hot exhaust air with the cold supply air, improving cooling efficiency.

In alternative configurations, the rows 504 comprise single rows 504, with each single row 504 having a contained hot aisle 506 associated with only that single row 504. The sub-hall 102a, 102b may also comprise a combination of pairs of rows 504 with contained hot aisles 506 between them and single rows 504 with contained hot aisles 506 associated with only the single row 504.

A plurality of air circulation units 508 are positioned along one side of the sub-hall 102a, 102b. The air circulation units 508 are configured to provide cooling to the computer systems 502 within the sub-hall 102a, 102b. For example, the air circulation units 508 may take the form of prefabricated service modules.

The cooling corridor 126 is located at one end of the sub-hall 102a, 102b. The columns 128 are arranged at regular intervals throughout the structure. External wall panels 130 form the perimeter walls of the sub-hall 102a, 102b.

The modular cooling units 106 described above in relation to FIG. 1 and FIG. 2 may be configured to provide different types of cooling depending on the requirements of the computing equipment installed. The modular cooling units 106 may be dry cooling units that provide air cooling only, distributed chilled liquid cooling units that provide liquid cooling only, or a hybrid comprising both dry cooling units and distributed chilled liquid cooling units. The modular cooling units 106 may be chillers.

In the hybrid configuration, the modular cooling units 106 provide hybrid cooling comprising both air cooling and liquid cooling to the rack or to the chip level. The hybrid cooling system enables variable apportionment between air cooling and water cooling streams. Cooling water in the hybrid cooling system is split into two streams. A first stream provides air cooling via CRAC units (Computer Room Air Conditioning units), where chilled water is supplied to the CRAC units which then cool the air within the sub-hall 102a, 102b. A second stream provides direct water cooling to computer racks within the computer systems 502, bypassing the air cooling pathway and delivering cooling directly to the heat-generating components.

The hybrid cooling approach provides flexibility to accommodate different computing equipment with varying cooling requirements. Traditional air-cooled computing equipment receives cooling via the first stream through the CRAC units, while high-density computing equipment such as that used for artificial intelligence workloads receives direct liquid cooling via the second stream. The apportionment between the two streams is variable, enabling the cooling system to be configured according to the specific mix of computing equipment installed within the sub-hall 102a, 102b. In some cases, the modular cooling units 106 may be configured to provide only air cooling or only liquid cooling, depending on the specific requirements of the computing equipment and the preferences of the data centre operator.

Each row 504 is configured to comprise computer systems 502 with a specified power capacity. The row power capacity may be configured at 250 kW, 375 kW, or 750 kW average power per row 504, for example, to accommodate different computing densities. The 250 kW configuration accommodates traditional computing workloads with moderate power densities. The 375 kW and 750 kW configurations accommodate higher-density computing workloads including artificial intelligence workloads that require greater power and cooling capacity per unit of floor space.

Each row 504 may also have a maximum power requirement, such as 300 kW for a 250 kW average power row. The maximum power requirement represents the peak instantaneous power draw that the row 504 is designed to accommodate, accounting for transient load spikes that may occur during operation. The distinction between average power and maximum power is significant for the design of power distribution infrastructure, as the electrical systems must be sized to handle peak loads even though the average power consumption may be lower. The 300 kW maximum power requirement ensures that the power distribution units 510 and static transfer switches 512 serving each row 504 have sufficient capacity to handle peak demand without tripping protective devices or causing voltage drops that could affect computing equipment operation.

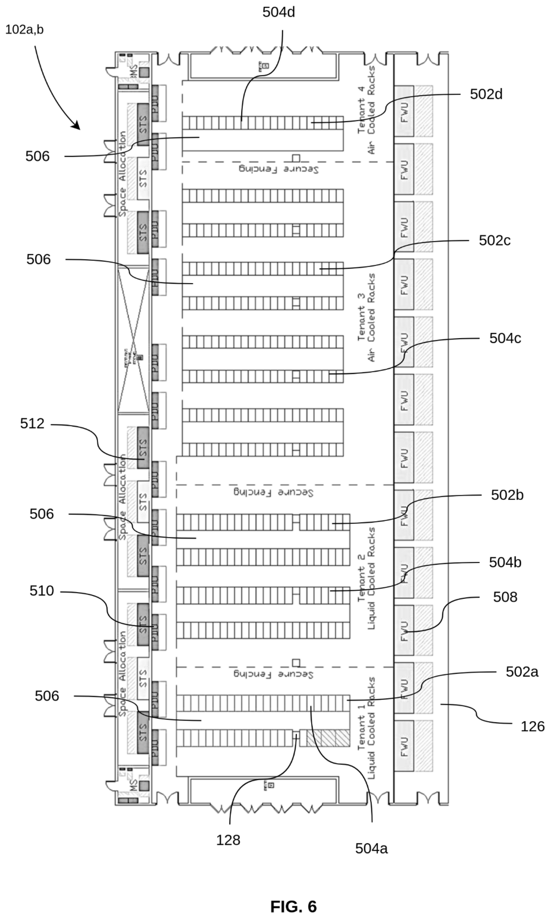

FIG. 6 illustrates a floor plan view of a sub-hall 102a, 102b of the modular data centre 100 showing the arrangement for multiple tenant areas. In the illustrated example, he sub-hall 102a, 102b is divided into four tenant areas separated by secure fencing and separate access controls, ensuring each tenant has access only to their area. Each tenant area is configured to house computer systems with specific cooling requirements, though other combinations of tenant area and cooling systems, in particular the implementation of hybrid air and water cooling systems as described above, are envisaged.

A first tenant area contains a plurality of computer systems 502a arranged in rows 504a. The computer systems 502a are liquid cooled racks configured to receive direct liquid cooling to the computing components within the racks. A second tenant area contains a plurality of computer systems 502b arranged in rows 504b. The computer systems 502b are also liquid cooled racks configured to receive direct liquid cooling. A third tenant area contains a plurality of computer systems 502c arranged in rows 504c. The computer systems 502c are air cooled racks configured to receive cooling via conditioned air supplied to the sub-hall 102a, 102b. A fourth tenant area contains a plurality of computer systems 502d arranged in rows 504d. The computer systems 502d are also air cooled racks configured to receive cooling via conditioned air.

The hot aisles 506 are positioned between pairs of rows 504a, 504b, 504c, 504d throughout the sub-hall 102a, 102b. The hot aisles 506 provide contained areas for hot exhaust air from the computer systems 502a, 502b, 502c, 502d.

A row of power supply equipment is positioned along one edge of the sub-hall 102a, 102b adjacent to the service corridor 124. Each power supply module 104 is associated with power supply equipment comprising a static transfer switch 512 and a power distribution unit 510. The static transfer switches 512 are positioned along the back wall of the service corridor 124. The power distribution units 510 are positioned adjacent to the static transfer switches 512.

The static transfer switches 512 provide automatic transfer capability between primary and reserve power supplies. Each static transfer switch 512 is configured to monitor the incoming power supply and automatically transfer to an alternative power source if the primary supply fails or falls outside acceptable voltage or frequency parameters. The transfer time of the static transfer switches 512 is sufficiently rapid to prevent interruption to the computer systems 502a, 502b, 502c, 502d, typically completing the transfer within milliseconds. This rapid transfer capability ensures continuous operation of the computing equipment during power supply transitions.

The power distribution units 510 are configured to distribute electrical power from the static transfer switches 512 to the individual computer systems 502a, 502b, 502c, 502d within each row 504a, 504b, 504c, 504d. Each power distribution unit 510 includes circuit breakers and monitoring equipment to protect the downstream computing equipment and provide visibility of power consumption at the row level. The power distribution units 510 are sized to accommodate the maximum power requirement of the associated row 504a, 504b, 504c, 504d, ensuring sufficient capacity for peak load conditions.

A power supply module 104, as illustrated in FIGs. 1, 2 and 7, is configured to receive power from both a generator and a utility grid supply. The generator serves as a backup power source rather than the primary power source. The power supply module 104 includes a transformer for receiving utility grid power in addition to the generator power supply. This configuration enables the modular data centre 100 to operate primarily from utility grid power whilst maintaining backup generation capacity for use during grid outages or maintenance periods.

Each power supply module 104 provides two separate power distribution streams. A first power distribution stream is dedicated to IT load and is ring-fenced at a particular power value, such as 1.5 MW. A second power distribution stream is dedicated to building services and mechanical equipment and provides the remaining power that can be generated by the generator, which would be approximately 0.9 MW if the generator is a 2.4 MW generator and the IT power output is 1.5 MW. The separation of IT load from building services load enables independent management of power allocation and ensures that building services equipment does not draw power from the IT allocation.

The generator within each power supply module 104 may have a variety of power outputs, such as 2.4 MW, 3 MW, or 4 MW, depending on the capacity requirements of the associated portion of the data hall 102 and the availability of different generators. For a 3 MW generator with a 1.5 MW IT power allocation, the remaining 1.5 MW would be available for building services and mechanical equipment. For a 4 MW generator with a 1.5 MW IT power allocation, the remaining 2.5 MW would be available for building services and mechanical equipment. Alternatively, larger generators may be paired with higher IT power allocations, such as a 4 MW generator providing 2.5 MW of IT power and 1.5 MW for building services.

The air circulation units 508 are positioned along the opposite edge of the sub-hall 102a, 102b from the power supply equipment, in the cooling corridor 126. The columns 128 are arranged at regular intervals throughout the structure according to the first common spacing α in a length direction (between the top and bottom of the page) and the second common spacing β in a width direction (between the left and right edges of the page) described above in relation to FIG. 3.

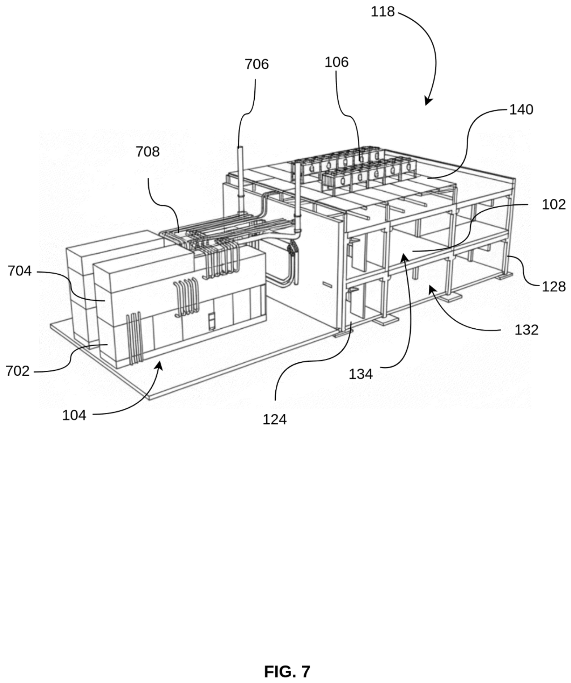

FIG. 7 illustrates an isometric view of a power supply module 104 arrangement showing the structural configuration and component layout adjacent to a middle portion 118 of the data hall 102. The figure illustrates two power supply modules 104 adjacent to the middle portion 118. In some configurations, each portion may have two power supply modules 104 associated with it, where one power supply module 104 provides the primary power supply for the portion and the other power supply module 104 may provide a redundancy power supply. In other configurations, each portion may have a single power supply module 104 associated with it, with one or more additional redundancy power supply modules shared between multiple portions. The exemplary power supply module 104 comprises a stacked container arrangement with multiple distinct sections configured to provide electrical power to the associated middle portion 118 of the data hall 102.

A generator enclosure 702 is positioned at the lower level, forming the base of the stacked arrangement. The generator enclosure 702 houses a generator configured to provide backup power to the data hall 102. The generator enclosure 702 can include acoustic louvres for inlet and outlet air attenuation, reducing noise emissions from the generator during operation. The generator enclosure 702 may include a belly tank fuel storage integrated within the enclosure frame, for exampleproviding up to 48 hours of fuel storage, enabling extended operation during utility grid outages without requiring external fuel delivery.

An electrical pod 704 is positioned above the generator enclosure 702. The electrical pod 704 houses electrical distribution equipment configured to receive power from both the generator enclosure 702 and a utility grid supply, and distribute the power to the data hall 102. The electrical pod 704 includes a transformer for receiving utility grid power, enabling the modular data centre 100 to operate primarily from utility grid power whilst maintaining backup generation capacity from the generator enclosure 702 for use during grid outages or maintenance periods. The electrical pod 704 and the generator pod 704 are designed to be manufacturer-agnostic, capable of accommodating equipment from multiple manufacturers including Schneider, Eaton, and MTU. This manufacturer-agnostic design enables procurement flexibility and avoids dependency on a single equipment supplier.

The electrical pod 704 houses all of the electrical components for providing power to the respective portion that it is associated with, including the IT power required by that portion and ancillary power, such as for cooling. The electrical components include battery and medium voltage (MV) equipment, low voltage (LV) equipment and a transformer, and uninterruptible power supply (UPS) equipment.

Cable routing infrastructure 708 connects the power supply module 104 to the data hall 102. The cable routing infrastructure 708 extends from the electrical pod 704 across the gap between the power supply module 104 and the data hall 102, entering the data hall 102 through the service corridor 124. The cable routing infrastructure 708 carries electrical power cables and control cables between the power supply module 104 and the electrical distribution equipment within the service corridor 124.

The power supply module 104 is designed as a modular, standardised unit that can be manufactured in volume and deployed across multiple data centre installations. This can significantly increases the speed of constructing data centres compared to conventional bespoke power infrastructure installations, as well as enabling scalability for data centre operators. Each power supply module 104 may have identical specifications and configurations, enabling mass production efficiencies that reduce per-unit manufacturing costs compared to bespoke power supply installations designed individually for each data centre project. The standardisation of power supply modules 104 also simplifies procurement, as identical units can be ordered in varying quantities depending on the required data centre capacity, and enables the establishment of supply chain relationships with manufacturers who can produce these units at scale.

The power supply module 104 dimensions may be designed to approximate standard shipping container dimensions of approximately 2.4 metres wide by 12.2 metres long. These dimensions enable ease of transport using standard transportation equipment, including via rail and road. For example, the power supply module 104 may configured to be transported on a standard flatbed lorry without requiring convoy arrangements, simplifying logistics and reducing transportation costs. The container-like dimensions also enable the power supply modules 104 to be manufactured off-site in a controlled factory environment and delivered to site fully assembled and pre-tested, reducing on-site installation time and ensuring consistent quality across all units. This approach eliminates the need for extensive on-site installation work that would typically be required for traditional power supply infrastructure, enabling faster deployment timelines and reducing reliance on skilled on-site labour, while improving site safety.

The modular and standardised nature of the power supply modules 104 provides additional benefits for maintenance and replacement operations. Because each power supply module 104 may be identical, spare parts and replacement components can be stocked efficiently, and maintenance personnel become proficient in servicing a single standardised configuration rather than multiple bespoke installations. In the event of a failure, an entire power supply module 104 can be replaced with a pre-manufactured unit, minimising or even eliminating downtime compared to traditional power infrastructure where repairs must be conducted in situ.

The service corridor 124 is visible between the power supply module 104 and the data hall 102. The data hall 102 structure includes columns 128 arranged in a regular grid pattern, with the ground floor 132 and the first floor 134 visible. The modular cooling units 106 are mounted on the roof of the data hall 102, supported by the cooling unit platform 140 .

The positioning of the service corridor 124 adjacent to the power supply modules 104 is configured to minimise the length of cable runs between the power supply modules 104 and the electrical distribution equipment within the data hall 102. Shorter cable lengths reduce electrical losses due to resistance in the conductors, improving overall power distribution efficiency. The reduced cable lengths also decrease the quantity of cabling material required, reducing both material costs and installation time. Furthermore, shorter cable runs simplify cable management and reduce the complexity of cable routing, making installation and future maintenance operations more straightforward. The proximity of the service corridor 124 to the power supply modules 104 also facilitates fault diagnosis and repair, as the electrical infrastructure connecting the power supply modules 104 to the data hall 102 is concentrated in an accessible location rather than being distributed throughout the facility.

The middle portion 118 illustrated in FIG. 7 demonstrates the repeatable unit configuration of the data hall 102. The middle portion 118 comprises a section of the data hall 102 with associated power supply module 104, modular cooling units 106, and service corridor 124 infrastructure. Additional middle portions 118 are added to extend the data hall 102 by replicating the configuration illustrated in FIG. 7. Because each portion (first end portion 114, second end portion 116, and middle portions 118) has its own associated power supply module 104, the power capacity of the modular data centre 100 scales proportionally with the size of the data hall 102. When additional middle portions 118 are added to extend the data hall 102, each additional middle portion 118 brings its own power supply module 104, ensuring that power capacity automatically scales with the data hall 102 size. This eliminates the need for complex recalculations of power infrastructure when adjusting data centre capacity, as the power requirements are predetermined and factored into the design of each portion.

The middle portion 118 is converted into an end portion 114, 116 or an intermediate portion 120, 122 by varying the precast components used in construction. The type of column 128 used varies depending on the position of the portion within the data hall 102. Columns 128 at the end of the data hall 102 require fewer connections than columns 128 in the middle of the data hall 102, as end columns 128 receive beams from fewer directions. The floor planks 138 and external wall panels 130 similarly vary depending on the position of the portion within the data hall 102. End portions 114, 116 include external wall panels 130 at the end of the data hall 102, while middle portions 118 positioned between other portions do not require external wall panels 130 at the boundaries with adjacent portions. Intermediate portions 120, 122 include partition walls or fire separation elements at the boundary between the first sub-hall 102a and the second sub-hall 102b. By selecting the appropriate precast components for each position, the same basic portion configuration is adapted to serve as a first end portion 114, a second end portion 116, a middle portion 118, a first intermediate portion 120, or a second intermediate portion 122.

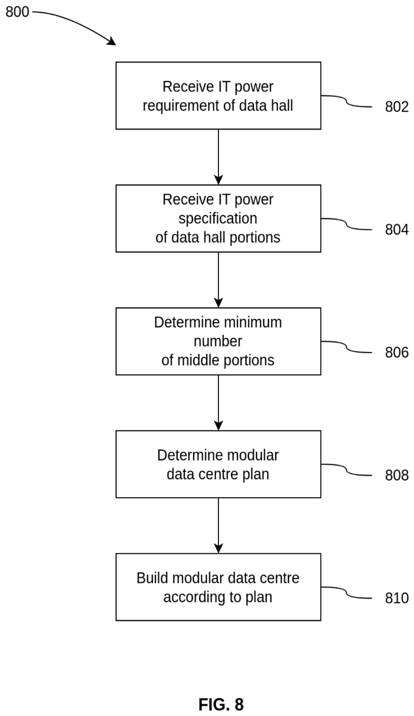

FIG. 8 illustrates a flowchart of a method 800 for building a modular data centre 100 comprising a data hall 102. The method 800 enables scalable deployment of data centres by determining the appropriate size of the data hall 102 based on capacity requirements and then constructing the data hall 102 using the repeatable portion configuration and modular construction techniques described above.

The method 800 includes a step 802 of receiving an IT power requirement of the data hall 102. The IT power requirement represents the total computing power capacity that the data hall 102 is required to provide. The IT power requirement may be specified by a client, such as a hyperscaler operator, based on the computing workloads that the data hall 102 is intended to support. The IT power requirement may be expressed in megawatts, such as 1.5 MW, 3 MW, 4.5 MW, 9 MW, 18 MW, 27 MW, 36 MW, 45 MW, 54 MW, 72 MW or 108 MW.

The IT power requirement may also be determined based on the number and type of computer racks to be installed within the data hall 102. Different computing applications require different power densities per rack, with traditional computing workloads typically requiring lower power per rack compared to high-performance computing or artificial intelligence workloads. The IT power requirement accounts for the aggregate power consumption of all computer racks planned for installation, including allowances for future expansion or changes in computing equipment. The step 802 may also involve receiving information regarding the intended computer rack configuration, such as the number of rows 504, the power density per row, and whether the racks will be air cooled or liquid cooled, as these factors influence the overall IT power requirement and the associated cooling infrastructure requirements.

In configurations where the data hall 102 is divided into the first sub-hall 102a and the second sub-hall 102b, the IT power specification may be received separately for each sub-hall. This enables different sub-halls to be configured with different power capacities to accommodate different client requirements. For example, the first sub-hall 102a may be configured with higher power density portions to accommodate artificial intelligence workloads, while the second sub-hall 102b may be configured with standard power density portions for traditional computing workloads.

The method 800 proceeds to a step 804 of receiving an IT power specification of portions of the data hall 102. The IT power specification defines the IT power capacity of the first end portion 114, the second end portion 116, and the middle portion 118. Each portion has a predetermined IT power capacity based on the power supply module 104 associated with that portion. For example, if each portion has a single power supply module 104 associated with it, and each power supply module 104 provides 1.5 MW of IT power, then each portion has an IT power specification of 1.5 MW. The IT power specification is predetermined based on the design of the power supply modules 104 and the electrical distribution infrastructure within each portion.

The IT power specification may vary depending on the configuration of power supply modules 104 associated with each portion. In some configurations, each portion may have a single power supply module 104 associated with it, providing a base IT power capacity such as 1.5 MW per portion. In other configurations, each portion may have two power supply modules 104 associated with it, effectively doubling the IT power capacity per portion to 3 MW. The choice of configuration depends on the power density requirements of the computing equipment to be installed and the redundancy requirements specified by the data centre operator.

The IT power specification may also account for different power supply module 104 capacities. Power supply modules 104 with larger generators, such as 3 MW or 4 MW generators, provide higher IT power allocations per module. A power supply module 104 with a 3 MW generator may provide 2 MW of IT power, while a power supply module 104 with a 4 MW generator may provide 2.5 MW of IT power. The selection of power supply module 104 capacity influences the IT power specification of each portion and consequently affects the number of portions required to meet a given IT power requirement.

The step 802 or 804 may also involve receiving information regarding redundancy requirements. Data centre operators generally require N+1 redundancy, where one additional power supply module 104 is provided for every N operational modules to ensure continued operation in the event of a module failure. Other operators may require 2N redundancy, where the power supply capacity is fully duplicated. The redundancy requirement influences the total number of power supply modules 104 required and may affect the IT power specification attributed to each portion, as some power supply modules 104 may be designated as redundancy modules rather than primary power sources.

The method 800 then proceeds to a step 806 of determining a minimum number of middle portions 118 required such that the sum of the IT power specifications of the first end portion 114, the second end portion 116, and the middle portions 118 is greater than or equal to the IT power requirement received in step 802. The determination involves calculating how many middle portions 118 are needed to meet the specified IT power requirement. For example, if the IT power requirement is 9 MW and each portion provides 1.5 MW of IT power, then the minimum number of portions required is six. Accounting for the first end portion 114 and the second end portion 116, the minimum number of middle portions 118 required would be four.

In configurations where the data hall 102 is divided into the first sub-hall 102a and the second sub-hall 102b, the step 806 may involve determining the number of middle portions 118 for each sub-hall separately. The first intermediate portion 120 and the second intermediate portion 122 are positioned between the middle portions 118 to create the separation between sub-halls. The determination may account for the IT power requirements of each sub-hall independently, enabling different sub-halls to have different numbers of middle portions 118 based on their respective capacity requirements. For example, if the first sub-hall 102a requires 6 MW of IT power and the second sub-hall 102b requires 3 MW of IT power, and each portion provides 1.5 MW, then the first sub-hall 102a would require four portions (including the first end portion 114, the first intermediate portion 120, and two middle portions 118) while the second sub-hall 102b would require two portions (including the second intermediate portion 122 and the second end portion 116). The intermediate portions 120, 122 are included in the calculation if they each have their own associated power supply module 104 and contribute to the overall IT power capacity of the data hall 102.

The method 800 continues to a step 808 of determining a modular data centre plan. The step 808 includes determining a data hall plan by arranging the middle portions 118 in a repeating linear fashion between the first end portion 114 and the second end portion 116. The modular data centre plan defines the layout of the data hall 102, including the positions of the first end portion 114, the second end portion 116, and each of the middle portions 118. The modular data centre plan also includes arranging each power supply module 104 adjacent to and structurally separate from the associated first end portion 114, second end portion 116, or middle portion 118.

In configurations where the data hall 102 is divided into the first sub-hall 102a and the second sub-hall 102b, the step 808 further comprises arranging the first intermediate portion 120 and the second intermediate portion 122 positioned adjacent to one another and between two of the middle portions 118. The first intermediate portion 120 and the second intermediate portion 122 separate the data hall 102 into the first sub-hall 102a and the second sub-hall 102b. The data hall plan may be symmetric in layout about the join between the first intermediate portion 120 and the second intermediate portion 122.

The step 808 may also include determining a number of additional power supply modules 104 in addition to the power supply modules 104 associated with the first end portion 114, the second end portion 116, and the middle portions 118. The additional power supply modules 104 may be configured to provide a power supply for the logistics building 108, a power supply for the administrative building 110, or a redundancy power supply for the modular data centre 100. The modular data centre plan includes arranging the additional power supply modules 104 adjacent to and structurally separate from the data hall 102.

The step 808 may further include determining, based on the determined data hall plan, a plurality of prefabricated components required for constructing the superstructure and facade of the data hall 102. The determination involves calculating the number and types of columns 128, prefabricated beams, floor planks 138, and external wall panels 130 required based on the number of portions in the data hall plan and the structural requirements of each portion. Because the middle portions 118 have the same structure, the prefabricated components for each middle portion 118 are identical, enabling the total quantity of each component type to be calculated by multiplying the per-portion requirement by the number of middle portions 118 (taking into account any overlap in components, such as columns, at the join between portions) and adding the components required for the first end portion 114 and the second end portion 116. The determination may also include calculating the prefabricated services distribution modules required for the service corridor 124 and the prefabricated service modules required for the cooling corridor 126, along with any other modular or prefabricated components. This approach enables very simple yet accurate procurement of prefabricated components prior to commencing on-site construction, reducing the risk of delays due to component shortages and enabling efficient scheduling of deliveries to site.

The method 800 concludes with a step 810 of building the modular data centre 100 according to the determined modular data centre plan. The step 810 includes building the data hall 102 according to the determined data hall plan. Building the data hall 102 comprises assembling the prefabricated structural components, including the columns 128, prefabricated beams, floor planks 138, and external wall panels 130, according to the positions defined in the data hall plan. The step 810 also includes installing the power supply modules 104 in the positions defined in the modular data centre plan, installing the service corridor 124 infrastructure, and installing the modular cooling units 106.

The step 810 may further comprise receiving the power supply modules 104 at the site for the modular data centre 100. The power supply modules 104 are manufactured off-site in a controlled factory environment and delivered to site fully assembled and pre-tested. Each power supply module 104 is transported to site using standard transportation equipment, such as flatbed lorries, due to the container-like dimensions of the power supply modules 104. Upon arrival at site, the power supply modules 104 are positioned in the locations defined in the modular data centre plan using cranes or other lifting equipment. The pre-assembled and pre-tested nature of the power supply modules 104 eliminates the need for extensive on-site electrical installation work, enabling rapid deployment and reducing reliance on skilled on-site labour. The power supply modules 104 are then connected to the electrical distribution infrastructure within the service corridor 124 via the cable routing infrastructure 708.

The method 800 enables scalable deployment of data centres by adjusting the number of middle portions 118 based on capacity requirements. Because each middle portion 118 has a predetermined IT power specification and an associated power supply module 104, the total IT power capacity of the data hall 102 scales proportionally with the number of middle portions 118. A data centre operator requiring a larger IT power capacity specifies a higher IT power requirement in step 802, which results in a greater number of middle portions 118 being determined in step 806. A data centre operator requiring a smaller IT power capacity specifies a lower IT power requirement, resulting in fewer middle portions 118.

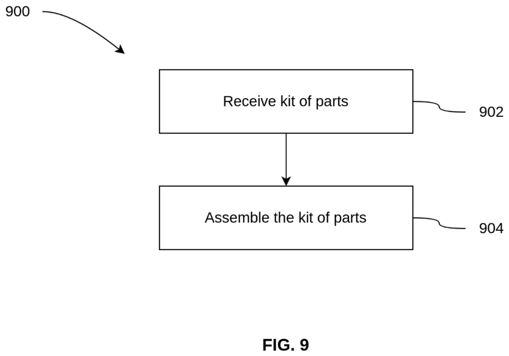

FIG. 9 illustrates a flowchart of a method 900 for assembling a modular data centre 100. The method 900 provides an approach for on-site assembly of the modular data centre 100 using prefabricated components that are manufactured off-site and delivered to site as a kit of parts.

The method 900 includes a step 902 of receiving a kit of parts. The kit of parts comprises the plurality of power supply modules 104 and prefabricated components configured to be assembled into the structure of the data hall 102. The prefabricated components include the columns 128, prefabricated beams, floor planks 138, and external wall panels 130 described above in relation to FIGs. 3 and 4. The kit of parts also includes the prefabricated services distribution modules for installation within the service corridor 124 and the prefabricated service modules for installation within the cooling corridor 126.

The kit of parts is configured such that all components required for constructing the modular data centre 100 are delivered to site in a coordinated manner. The components are manufactured off-site in controlled factory environments, enabling consistent quality and dimensional accuracy. Each component in the kit of parts is manufactured to predetermined specifications that correspond to the modular data centre plan determined in the method 800 described above in relation to FIG. 8. The standardised nature of the components enables quality control during manufacturing, as each component type is produced using established processes and can be inspected against defined tolerances before dispatch to site.

The power supply modules 104 within the kit of parts are delivered to site fully assembled and pre-tested, or may come in one or more sub-modules that can be assembled on site (e.g., by stacking). Each power supply module 104 includes the generator enclosure 702, the electrical pod 704, and the cable routing infrastructure 708 in a pre-assembled configuration. An exhaust flu 706 provides an exhaust output from the generator enclosure 702. The pre-assembly and pre-testing of the power supply modules 104 in a factory environment ensures that electrical systems are functional before arrival at site, reducing the risk of on-site commissioning issues and enabling rapid deployment.

The method 900 proceeds to a step 904 of assembling the kit of parts on site. The step 904 involves positioning and connecting the prefabricated components according to the modular data centre plan. The columns 128 are positioned on the foundation 136 at locations defined by the first common spacing α and the second common spacing β. The prefabricated beams are lifted into position and connected to the connections (e.g., corbels) on the columns 128. The floor planks 138 are positioned on the prefabricated beams to create the floor surfaces for the ground floor 132 and the first floor 134. The external wall panels 130 are lifted into position and secured to the columns 128 to form the perimeter walls of the data hall 102.

The step 904 also involves positioning the power supply modules 104 adjacent to the data hall 102 in the locations defined in the modular data centre plan. The power supply modules 104 may be lifted into position using cranes and placed on the foundation 136 in the service yard area. The cable routing infrastructure 708 is connected between each power supply module 104 and the service corridor 124 to establish electrical connections between the power supply modules 104 and the electrical distribution equipment within the data hall 102.

The kit of parts approach enables rapid on-site assembly with reduced reliance on skilled on-site labour. Because the components are prefabricated off-site, the on-site work consists primarily of positioning and connecting pre-manufactured elements rather than fabricating components in situ. This approach reduces the need for wet trades on site, as the prefabricated columns 128, floor planks 138, and external wall panels 130 arrive at site fully cured and ready for installation. The elimination of on-site concrete curing time accelerates the construction schedule compared to traditional cast-in-place construction methods.

The standardised nature of the components enables predictable assembly processes. Because each component type is manufactured to consistent specifications, the connection details between components are uniform throughout the structure. Workers assembling the kit of parts become proficient in handling and installing a limited set of component configurations, reducing installation time and the potential for errors. The predictability of the assembly process also enables accurate scheduling of construction activities, as the time required to install each component type can be estimated based on established installation rates.

The kit of parts approach also improves site safety. The prefabricated services distribution modules are assembled at ground level in a factory environment before being raised into position within the service corridor 124, reducing the need for workers to install services overhead at height. The pre-assembly of the power supply modules 104 eliminates the need for extensive on-site electrical installation work within confined spaces, reducing exposure to electrical hazards during construction.

The design and determination steps described in the methods 800 and 900 may be performed by a computer system executing software configured to automate the modular data centre planning process. The computer system may receive the IT power requirement as an input and automatically determine the minimum number of middle portions 118 required, generate the modular data centre plan, and calculate the quantities of each prefabricated component type needed for construction. The automated determination of prefabricated components enables the generation of procurement lists and delivery schedules without manual calculation, reducing the potential for errors and accelerating the planning phase. The computer system may also generate assembly instructions and sequencing information for the on-site construction team based on the determined modular data centre plan. This automation of the design and planning process enables rapid response to client requirements, as a complete modular data centre plan can be generated within a short timeframe once the IT power requirement is specified.

Features of any of the examples or embodiments outlined above may be combined to create additional examples or embodiments without losing the intended effect. It should be understood that the description of an embodiment or example provided above is by way of example only, and various modifications could be made by one skilled in the art. Furthermore, one skilled in the art will recognise that numerous further modifications and combinations of various aspects are possible. Accordingly, the described aspects are intended to encompass all such alterations, modifications, and variations that fall within the scope of the appended claims.

The following clauses set out certain combinations of features contemplated by the present disclosure:
Clause 1. A modular data centre comprising a plurality of power supply modules and a data hall for housing a plurality of computer systems, the data hall having a first end portion, a second end portion, and one or more middle portions arranged in a repeating linear fashion between the first end portion and the second end portion so as to form the data hall; wherein each of the first end portion, the second end portion, and the one or more middle portions has a respective one of the plurality of power supply modules associated with it that is configured to provide a power required by that portion when the data centre is in operation; wherein each power supply module is structurally separate from its associated first end portion, second end portion or middle portion.
Clause 2. The modular data centre of clause 1, wherein the one or more middle portions is a plurality of middle portions, and wherein each of the plurality of middle portions has the same structure.
Clause 3. The modular data centre of clause 2, the data hall further having a first intermediate portion and a second intermediate portion, the first intermediate portion and the second intermediate portion positioned adjacent to one another and between two of the one or more middle portions, the first intermediate portion and the second intermediate portion configured to separate the data hall into a first sub-hall and a second sub-hall.
Clause 4. The modular data centre of clause 3, wherein the data hall is symmetric in layout about the join between the first intermediate portion and the second intermediate portion.
Clause 5. The modular data centre of any preceding clause, wherein each of the power supply modules is identical.
Clause 6. The modular data centre of any preceding clause, wherein each of the power supply modules is separated from the data hall by a gap of at least 1m, at least 2m, at least 3m, or at least 5m.
Clause 7. The modular data centre of any preceding clause, wherein each of the power supply modules is configured to provide either or both of 1.5 MW of IT power and 2.4 MW of total power.
Clause 8. The modular data centre of any preceding clause, wherein each of the first end portion, the second end portion, and the one or more middle portions are configured to house the plurality of computer systems in one or more rows.
Clause 9. The modular data centre of clause 8, wherein each row is associated with a hot aisle.
Clause 10. The modular data centre of clause 9, wherein: the one or more rows comprise pairs of rows, each pair of rows having a contained hot aisle between the two rows; or the one or more rows comprising single rows, each single row having a contained hot aisle associated with only that single row; or any combination of the above.
Clause 11. The modular data centre of any of clauses 8 to 10, wherein each row is configured to comprise computer systems that either: require an average power of 250 kW, 375 kW, or 750 kW; have a maximum power requirement of 300 kW, 500 kW, or 1000 kW; or both.
Clause 12. The modular data centre of any preceding clause, wherein the plurality of power supply modules comprises one or more additional power supply modules in addition to the power supply modules associated with the first end portion, the second end portion, and the one or more middle portions, the additional power supply modules configured to provide one or more of: a power supply for one or more logistics buildings of the modular data centre; a power supply for one or more administrative buildings of the modular data centre; or a redundancy power supply for the modular data centre.
Clause 13. The modular data centre of any preceding clause, wherein the plurality of power supply modules are arranged linearly and adjacent to the data hall, such that the power supply module associated with each of the first end portion, the second end portion, and the one or more middle portions is adjacent to its associated portion.
Clause 14. The modular data centre of any preceding clause, wherein each of the first end portion, the second end portion and the one or more middle portions comprise a modular cooling unit that is configured to provide a cooling required by that portion when the data centre is in operation.
Clause 15. The modular data centre of clause 14, wherein the modular cooling units are dry cooling units, distributed chilled liquid cooling units, or a hybrid comprising dry cooling units and distributed chilled liquid cooling units.
Clause 16. The modular data centre of any preceding clause, wherein a superstructure and a facade of the first end portion, the second end portion, and the one or more middle portions are constructed from prefabricated components.
Clause 17. The modular data centre of clause 16, wherein the prefabricated components comprise prefabricated superstructure and prefabricated facade components, wherein optionally the prefabricated superstructure and/or the prefabricated facade components are precast concrete components.
Clause 18. The modular data centre of clause 16 or 17, wherein a number of distinct types of prefabricated superstructure and facade components is no more than 50, or no more than 40, or no more than 30, or no more than 29.
Clause 19. The modular data centre of any of clauses 16 to 18, wherein the prefabricated superstructure components comprise prefabricated columns, prefabricated beams, prefabricated floor planks, and wherein the prefabricated facade components comprise prefabricated external wall panels.
Clause 20. The modular data centre of clause 19, wherein: the number of distinct types of prefabricated column is no more than 15, no more than 10, or no more than 7; or the number of distinct types of prefabricated beam is no more than 30, no more than 20, or no more than 17; or the number of distinct types of prefabricated floor planks is no more than 10, no more than 5, or no more than 2; or the number of distinct types of prefabricated external wall panels is no more than 10, no more than 5, no more than 4, or no more than 3; or any combination of the above.
Clause 21. The modular data centre of clause 19 or 20, wherein each of the columns has the same cross section.
Clause 22. The modular data centre of clause 21, wherein the cross section is 400mm by 400mm, 425mm by 425mm, 450mm by 450mm, 475mm by 475mm, 500mm by 500mm, 525mm by 525mm, 550mm by 550mm, 575 by 575mm, 600mm by 600mm, 625mm by 625mm, 650mm by 650mm, 675mm by 675mm, or 700mm by 700mm.
Clause 23. The modular data centre of any preceding clause, further comprising prefabricated services distribution modules.
Clause 24. The modular data centre of clause 23, wherein the prefabricated services distribution modules comprise main services distribution modules and above rack distribution modules.
Clause 25. The modular data centre of clause 24, wherein the main services distribution modules contain one or more of pipework, ductwork, power line containment, and data line containment.
Clause 26. The modular data centre of clause 25, further comprising a service corridor integral to the data hall and running through the first end portion, the second end portion, and the one or more middle portions along an edge of the data hall adjacent the plurality of power supply modules; wherein the main services distribution modules are fixed within the service corridor.
Clause 27. The modular data centre of clause 26, wherein the service corridor has a width of 4m.
Clause 28. The modular data centre of any of clauses 24 to 27, wherein the above rack services distribution modules are configured to distribute data lines and power lines to the plurality of computer systems.
Clause 29. The modular data centre of any preceding clause, further comprising prefabricated service modules.
Clause 30. The modular data centre of any preceding clause, wherein the data hall has a length in the direction in which the one or more middle portions arranged in a repeating linear fashion, and a width in a horizontal direction perpendicular to the length; wherein each of the first end portion, the second end portion, and the one or more middle portions comprise a plurality of columns, the columns of the first end portion, the second end portion, and the one or more middle portions being arranged with a common spacing in at least one of the length direction and the width direction.
Clause 31. The modular data centre of clause 30, wherein the columns of the first end portion, the second end portion, and the one or more middle portions have a first common spacing in the length direction, wherein the first common spacing is between 6000mm and 6200mm, or between 6060mm and 6100mm, or 6080mm.
Clause 32. The modular data centre of clause 30 or 31, wherein the columns of the first end portion, the second end portion, and the one or more middle portions have a second common spacing in the width direction, wherein the second common spacing is between 1200mm and 12400mm, or between 1220mm and 12200mm, or 12160mm.
Clause 33. The modular data centre of any of clauses 30 to 32, wherein the first end portion and a first adjacent one of the one or more middle portions have a plurality of shared columns along a boundary between the first end portion and the first adjacent one of the one or more middle portions in the width direction; and/or wherein the second end portion and a second adjacent one of the one or more middle portions have a plurality of shared columns along a boundary between the second end portion and the second adjacent one of the one or more middle portions in the width direction.
Clause 34. The modular data centre of any of clauses 30 to 33, further comprising a logistics building having a plurality of columns, the columns of the logistics building having the same common spacing in at least one of the length direction and the width direction as the first end portion, the second end portion, and the one or more middle portions.
Clause 35. The modular data centre of clause 34, where the logistics building is attached to an end, in the length direction, of the data hall.
Clause 36. The modular data centre of clause 34 or 35, wherein the logistics building has the same width as the data hall.
Clause 37. The modular data centre of any preceding clause, wherein the data hall comprises one floor, two floors, or three floors.
Clause 38. The modular data centre of any preceding clause, wherein the data centre is configured to provide an IT power of 1.5 MW, 3 MW, 4.5 MW, 9 MW, 18 MW, 27 MW, 36 MW, 45 MW, 54 MW, 72 MW or 108 MW.
Clause 39. The modular data centre of any preceding clause, comprising the plurality of computer systems housed within the data hall.
Clause 40. The modular data centre of clause 39, wherein the data hall is divided into a plurality of areas, each of the plurality of areas housing computer systems of a different type.
Clause 41. The modular data centre of clause 40, wherein each type of computer system has a different footprint within the data hall.
Clause 42. The modular data centre of clause 40 or 41, wherein the data hall comprises partitions between each of the plurality of areas.
Clause 43. A method for building a modular data centre comprising a data hall, the method comprising: receiving an IT power requirement of the data hall; receiving an IT power specification of a first end portion of the data hall, a second end portion of the data hall, and a middle portion of the data hall, each portion for housing a plurality of computer systems; determining a minimum number of middle portions required such that the sum of the IT power specifications of the first end portion, the second end portion, and the middle portions is greater or equal to the IT power requirement; determining a modular data centre plan, including determining a data hall plan by arranging the middle portions in a repeating linear fashion between the first end portion and the second end portion; and building the modular data centre, including building the data hall according to the determined data hall plan.
Clause 44. The method of clause 43, wherein the number of middle portions is two or more middle portions, and wherein each of the two or more middle portions has the same structural plan.
Clause 45. The method of clause 44, the data hall plan further having a first intermediate portion and a second intermediate portion; wherein determining the data hall plan further comprises arranging the first intermediate portion and the second intermediate portion positioned adjacent to one another and between two of the two or more middle portions, the first intermediate portion and the second intermediate portion configured to separate the data hall into a first sub-hall and a second sub-hall.
Clause 46. The method of clause 45, wherein the data hall plan is symmetric in layout about the join between the first intermediate portion and the second intermediate portion.
Clause 47. The method of any of clauses 43 to 46, wherein each of the first end portion, the second end portion, and the middle portions has a respective power supply module associated with it that is configured to provide a power required by that portion when the data centre is in operation; wherein determining the modular data centre plan further includes arranging each power supply module adjacent to and structurally separate from its associated first end portion, second end portion or middle portion.
Clause 48. The method of clause 47, wherein each power supply module is identical.
Clause 49. The method of any of clauses 43 to 48, wherein each of the power supply modules is separated, in the determined modular data centre plan, from the data hall by a gap of at least 1m, at least 2m, at least 3m, or at least 5m.
Clause 50. The method of any of clauses 43 to 49, wherein each of the power supply modules is configured to provide either or both of 1.5 MW of IT power and 2.4 MW of total power.
Clause 51. The method of any of clauses 43 to 50, wherein each of the first end portion, the second end portion, and the one or more middle portions are configured to house the plurality of computer systems in one or more rows; wherein determining the data hall layout includes determining an arrangement of computer systems within the data hall.
Clause 52. The method of clause 51, wherein each row is associated with a hot aisle.
Clause 53. The method of clause 52, wherein: the one or more rows comprise pairs of rows, each pair of rows having a contained hot aisle between the two rows; or the one or more rows comprising single rows, each single row having a contained hot aisle associated with only that single row; or any combination of the above.
Clause 54. The method of any of clauses 51 to 53, wherein each row is configured to comprise computer systems that either: require an average power of 250 kW, 375 kW, or 750 kW; have a maximum power requirement of 300 kW, 500 kW, or 1000 kW; or both.
Clause 55. The method of any of clauses 43 to 54, wherein arranging the power supply modules comprises arranging the power supply modules linearly and adjacent to the data hall, such that the power supply module associated with each of the first end portion, the second end portion, and the one or more middle portions is adjacent to its associated portion.
Clause 56. The method of any of clauses 43 to 55, further comprising determining a number of additional power supply modules in addition to the power supply modules associated with the first end portion, the second end portion, and the one or more middle portions, the additional power supply modules configured to provide one or more of: a power supply for one or more logistics buildings of the modular data centre; a power supply for one or more administrative buildings of the modular data centre; or a redundancy power supply for the modular data centre; wherein determining the modular data centre plan further includes arranging the additional power supply modules adjacent to and structurally separate from the data hall.
Clause 57. The method of any of clauses 43 to 56, wherein each of the first end portion, the second end portion and the one or more middle portions are configured to comprise a modular cooling unit that is configured to provide a cooling required by that portion when the data centre is in operation.
Clause 58. The method of clause 57, wherein the modular cooling units are dry cooling units, distributed chilled liquid cooling units, or a hybrid comprising dry cooling units and distributed chilled liquid cooling units.
Clause 59. The method of any of clauses 43 to 58, further comprising determining, based on the determined data hall layout, a plurality of prefabricated components required for constructing a superstructure and a facade of the data hall.
Clause 60. The method of clause 59, wherein the prefabricated components comprise prefabricated superstructure and prefabricated facade components, wherein optionally the prefabricated superstructure and/or the prefabricated facade components are precast concrete components.
Clause 61. The method of clause 59 or 60, wherein building the data hall according to the determined data hall plan comprises: receiving the determined plurality of prefabricated components at a site for the data hall; and assembling the determined plurality of prefabricated components on-site.
Clause 62. The method of any of clauses 59 to 61, wherein a number of distinct types of prefabricated superstructure and facade components is no more than 50, or no more than 40, or no more than 30, or no more than 29.
Clause 63. The method of any of clauses 59 to 62, wherein the prefabricated superstructure components comprise prefabricated columns, prefabricated beams, prefabricated floor planks, and wherein the prefabricated facade components comprise prefabricated external wall panels.
Clause 64. The method of clause 63, wherein: the number of distinct types of prefabricated column is no more than 15, no more than 10, or no more than 7; or the number of distinct types of prefabricated beam is no more than 30, no more than 20, or no more than 17; or the number of distinct types of prefabricated floor planks is no more than 10, no more than 5, or no more than 2; or the number of distinct types of prefabricated external wall panels is no more than 10, no more than 5, no more than 4, or no more than 3; or any combination of the above.
Clause 65. The method of clause 63 or 64, wherein each of the columns has the same cross section.
Clause 66. The method of clause 65, wherein the cross section is 400mm by 400mm, 425mm by 425mm, 450mm by 450mm, 475mm by 475mm, 500mm by 500mm, 525mm by 525mm, 550mm by 550mm, 575 by 575mm, 600mm by 600mm, 625mm by 625mm, 650mm by 650mm, 675mm by 675mm, or 700mm by 700mm.
Clause 67. The method of any of clauses 43 to 66, further comprising determining, based on the determined data hall layout, a plurality of prefabricated services distribution modules, and wherein building the data hall according to the determined data hall plan comprises: receiving the determined plurality of prefabricated services distribution modules at a site for the data hall; and installing the plurality of prefabricated services distribution modules.
Clause 68. The method of clause 67, wherein the prefabricated services distribution modules comprise main services distribution modules and above rack distribution modules.
Clause 69. The method of clause 68, wherein the main services distribution modules contain one or more of pipework, ductwork, power line containment, and data line containment.
Clause 70. The method of clause 68 or 69, wherein determining the modular data hall plan further includes determining a service corridor plan integral to the data hall and running through the first end portion, the second end portion, and the one or more middle portions along an edge of the data hall; wherein building the modular data centre comprises installing the prefabricated main services distribution modules within the service corridor.
Clause 71. The method of clause 70, wherein the service corridor has a width of 4m.
Clause 72. The method of any of clauses 68 to 71, wherein the above rack services distribution modules are configured to distribute data lines and power lines to the plurality of computer systems.
Clause 73. The method of any of clauses 43 to 72, further comprising determining, based on the determined data hall layout, a plurality of prefabricated service modules, and wherein building the data hall according to the determined data hall plan comprises: receiving the determined plurality of prefabricated service modules at a site for the data hall; and installing the plurality of prefabricated service modules.
Clause 74. The method of any of clauses 43 to 73, wherein the data hall plan has a length in the direction in which the one or more middle portions arranged in a repeating linear fashion, and a width in a horizontal direction perpendicular to the length; wherein each of the first end portion, the second end portion, and the middle portions comprise a plurality of column positions, the column positions of the first end portion, the second end portion, and the one or more middle portions being arranged with a common spacing in at least one of the length direction and the width direction.
Clause 75. The method of clause 74, wherein the column positions of the first end portion, the second end portion, and the one or more middle portions have a first common spacing in the length direction, wherein the first common spacing is between 6000mm and 6200mm, or between 6060mm and 6100mm, or 6080mm.
Clause 76. The method of clause 74 or 75, wherein the columns of the first end portion, the second end portion, and the one or more middle portions have a second common spacing in the width direction, wherein the second common spacing is between 1200mm and 12400mm, or between 1220mm and 12200mm, or 12160mm.
Clause 77. The method of any of clauses 74 to 76, wherein the first end portion and a first adjacent middle portion have a plurality of shared column positions along a boundary between the first end portion and the first adjacent middle portion in the width direction; and/or wherein the second end portion and a second adjacent middle portion have a plurality of shared column positions along a boundary between the second end portion and the second adjacent middle portion in the width direction.
Clause 78. The method of any of clauses 74 to 77, further comprising determining a logistics building plan having a plurality of column positions, the column positions of the logistics building having the same common spacing in at least one of the length direction and the width direction as the first end portion, the second end portion, and the middle portions.
Clause 79. The method of clause 78, where the logistics building plan is attached to an end, in the length direction, of the data hall plan.
Clause 80. The method of clause 78 or 79, wherein the logistics building plan has the same width as the data hall plan.
Clause 81. The method of any of clauses 43 to 80, wherein the data hall plan comprises one floor, two floors, or three floors.
Clause 82. The method of any of clauses 43 to 81, wherein the modular data centre is configured to provide an IT power of 1.5 MW, 3 MW, 4.5 MW, 9 MW, 18 MW, 27 MW, 36 MW, 45 MW, 54 MW, 72 MW or 108 MW.
Clause 83. A kit of parts for a modular data centre comprising a plurality of power supply modules and a data hall for housing a plurality of computer systems, the data hall having a first end portion, a second end portion, and one or more middle portions arranged in a repeating linear fashion between the first end portion and the second end portion so as to form the data hall, the kit of parts comprising: the plurality of power supply modules; and a plurality of prefabricated components configured to be assembled into a structure of the data hall.
Clause 84. The kit of parts of clause 83, wherein the prefabricated components comprise prefabricated superstructure and prefabricated facade components, wherein optionally the prefabricated superstructure and/or the prefabricated facade components are precast concrete components.
Clause 85. The kit of parts of clause 83 or 84, wherein a number of distinct types of prefabricated superstructure and facade components is no more than 50, or no more than 40, or no more than 30, or no more than 29.
Clause 86. The kit of parts of any of clauses 83 to 85, wherein the prefabricated superstructure components comprise prefabricated columns, prefabricated beams, prefabricated floor planks, and wherein the prefabricated facade components comprise prefabricated external wall panels.
Clause 87. The kit of parts of clause 86, wherein: the number of distinct types of prefabricated column is no more than 15, no more than 10, or no more than 7; or the number of distinct types of prefabricated beam is no more than 30, no more than 20, or no more than 17; or the number of distinct types of prefabricated floor planks is no more than 10, no more than 5, or no more than 2; or the number of distinct types of prefabricated external wall panels is no more than 10, no more than 5, no more than 4, or no more than 3; or any combination of the above.
Clause 88. The kit of parts of clause 86 or 87, wherein each of the columns has the same cross section.
Clause 89. The kit of parts of clause 88, wherein the cross section is 400mm by 400mm, 425mm by 425mm, 450mm by 450mm, 475mm by 475mm, 500mm by 500mm, 525mm by 525mm, 550mm by 550mm, 575 by 575mm, 600mm by 600mm, 625mm by 625mm, 650mm by 650mm, 675mm by 675mm, or 700mm by 700mm.
Clause 90. The kit of parts of any of clauses 83 to 89, further comprising prefabricated services distribution modules.
Clause 91. The kit of parts of clause 90, wherein the prefabricated services distribution modules comprise main services distribution modules and above rack distribution modules.
Clause 92. The kit of parts of clause 91, wherein the main services distribution modules contain one or more of pipework, ductwork, power line containment, and data line containment.
Clause 93. The kit of parts of clause 91 or 92, wherein the above rack services distribution modules are configured to distribute data lines and power lines to the plurality of computer systems.
Clause 94. The kit of parts of any of clauses 83 to 93, further comprising prefabricated service modules.
Clause 95. A method of assembling a modular data centre comprising: receiving the kit of parts of any of clauses 83 to 94; and assembling the kit of parts.

## Claims

1. A modular data centre comprising a plurality of power supply modules and a data hall for housing a plurality of computer systems, the data hall having a first end portion, a second end portion, and one or more middle portions arranged in a repeating linear fashion between the first end portion and the second end portion so as to form the data hall;
wherein each of the first end portion, the second end portion, and the one or more middle portions has a respective one of the plurality of power supply modules associated with it that is configured to provide a power required by that portion when the data centre is in operation;
wherein each power supply module is structurally separate from its associated first end portion, second end portion or middle portion.

2. The modular data centre of claim 1, wherein the one or more middle portions is a plurality of middle portions, and wherein each of the plurality of middle portions has the same structure and/or wherein each of the power supply modules is identical.

3. The modular data centre of any preceding claim, wherein the plurality of power supply modules are arranged linearly and adjacent to the data hall, such that the power supply module associated with each of the first end portion, the second end portion, and the one or more middle portions is adjacent to its associated portion.

4. The modular data centre of any preceding claim, wherein each of the first end portion, the second end portion and the one or more middle portions comprise a modular cooling unit that is configured to provide a cooling required by that portion when the data centre is in operation;
wherein optionally the modular cooling units are dry cooling units, distributed chilled liquid cooling units, or a hybrid comprising dry cooling units and distributed chilled liquid cooling units.

5. The modular data centre of any preceding claim, wherein a superstructure and a facade of the first end portion, the second end portion, and the one or more middle portions are constructed from prefabricated components; wherein optionally the prefabricated superstructure components comprise prefabricated columns, prefabricated beams, prefabricated floor planks, and/or wherein the prefabricated facade components comprise prefabricated external wall panels.

6. The modular data centre of any preceding claim, further comprising prefabricated services distribution modules, wherein the prefabricated services distribution modules comprise main services distribution modules and/or above rack distribution modules.

7. The modular data centre of claim 6, further comprising a service corridor integral to the data hall and running through the first end portion, the second end portion, and the one or more middle portions along an edge of the data hall adjacent the plurality of power supply modules;
wherein the main services distribution modules are fixed within the service corridor.

8. The modular data centre of any preceding claim, further comprising prefabricated service modules.

9. The modular data centre of any preceding claim, wherein the data hall has a length in the direction in which the one or more middle portions arranged in a repeating linear fashion, and a width in a horizontal direction perpendicular to the length;
wherein each of the first end portion, the second end portion, and the one or more middle portions comprise a plurality of columns, the columns of the first end portion, the second end portion, and the one or more middle portions being arranged with a common spacing in at least one of the length direction and the width direction;
wherein the common spacing includes a first common spacing in the length direction of between 6000mm and 6200mm, or between 6060mm and 6100mm, or 6080mm; and/or
wherein common pacing includes a second common spacing in the length direction of between 1200mm and 12400mm, or between 1220mm and 12200mm, or 12160mm.

10. A method for building a modular data centre comprising a data hall, the method comprising:
receiving an IT power requirement of the data hall;
receiving an IT power specification of a first end portion of the data hall, a second end portion of the data hall, and a middle portion of the data hall, each portion for housing a plurality of computer systems;
determining a minimum number of middle portions required such that the sum of the IT power specifications of the first end portion, the second end portion, and the middle portions is greater or equal to the IT power requirement;
determining a modular data centre plan, including determining a data hall plan by arranging the middle portions in a repeating linear fashion between the first end portion and the second end portion; and
building the modular data centre, including building the data hall according to the determined data hall plan.

11. The method of claim 10, wherein each of the first end portion, the second end portion, and the middle portions has a respective power supply module associated with it that is configured to provide a power required by that portion when the data centre is in operation;
wherein determining the modular data centre plan further includes arranging each power supply module adjacent to and structurally separate from its associated first end portion, second end portion or middle portion.

12. The method of claim 10 or 11, further comprising determining, based on the determined data hall layout, a plurality of prefabricated components required for constructing a superstructure and a facade of the data hall; and
wherein building the data hall according to the determined data hall plan comprises:
receiving the determined plurality of prefabricated components at a site for the data hall; and
assembling the determined plurality of prefabricated components on-site.

13. The method of any of claims 10 to 12, further comprising determining, based on the determined data hall layout, a plurality of prefabricated services distribution modules, and wherein building the data hall according to the determined data hall plan comprises:
receiving the determined plurality of prefabricated services distribution modules at a site for the data hall; and
installing the plurality of prefabricated services distribution modules.

14. A kit of parts for a modular data centre comprising a plurality of power supply modules and a data hall for housing a plurality of computer systems, the data hall having a first end portion, a second end portion, and one or more middle portions arranged in a repeating linear fashion between the first end portion and the second end portion so as to form the data hall, the kit of parts comprising:
the plurality of power supply modules; and
a plurality of prefabricated components configured to be assembled into a structure of the data hall.

15. A method of assembling a modular data centre comprising:
receiving the kit of parts of claim 14; and
assembling the kit of parts.
